# EUROPEAN PATENT APPLICATION

(11) **EP 2 680 328 A2**
(43) Date of publication of application: **01.01.2014**
(21) Application number: 13174268.6
(22) Date of filing: 28.06.2013
(51) Int. Cl.: H01L 33/50

(54) **Phosphor layer-covered LED, producing method thereof, and LED device**

(30) Priority: 29.06.2012 JP 2012147550; 30.01.2013 JP 2013015783
(71) Applicant: NITTO DENKO CORPORATION, Ibaraki-shi, Osaka 567-8680 (JP)
(72) Inventor: Kimura, Ryuichi, Osaka, 567-8680 (JP); Katayama, Hiroyuki, Osaka, 567-8680 (JP); Ebe, Yuki, Osaka, 567-8680 (JP); Onishi, Hidenori, Osaka, 567-8680 (JP); Fuke, Kazuhiro, Osaka, 567-8680 (JP)
(74) Representative: HOFFMANN EITLE

(57) **Abstract**

A method for producing a phosphor layer-covered LED (10) includes the steps of preparing a support sheet (1) including a hard support board (2) and a pressure-sensitive adhesive layer (3) laminated at one surface in a thickness direction of the support board and having a pressure-sensitive adhesive force capable of being reduced by application of an active energy ray; attaching an LED (4) to the support board (2) via the pressure-sensitive adhesive layer (3); disposing a phosphor layer (5) at the one surface in the thickness direction of the support board so as to cover the LED with the phosphor layer; cutting the phosphor layer (5) corresponding to the LED (4) to produce a phosphor layer-covered LED (10) including the LED and the phosphor layer covering the LED; and peeling the phosphor layer-covered LED (10) from the pressure-sensitive adhesive layer (3) by applying an active energy ray at least from one side in the thickness direction to the pressure-sensitive adhesive layer.

## Description

### BACKGROUND OF THE INVENTION

### Field of the Invention

The present invention relates to a phosphor layer-covered LED, a producing method thereof, and an LED device, to be specific, to a method for producing a phosphor layer-covered LED, a phosphor layer-covered LED obtained by the method, and an LED device including the phosphor layer-covered LED.

### Description of Related Art

It has been known that, conventionally, a light emitting diode device (hereinafter, abbreviated as an LED device) is produced as follows: first, a plurality of light emitting diode elements (hereinafter, abbreviated as LEDs) are mounted on a board; next, a phosphor layer is provided so as to cover a plurality of the LEDs; and thereafter, the resulting products are singulated into individual LEDs.

Unevenness in emission wavelength and luminous efficiency is generated between a plurality of the LEDs, however, so that in such an LED device mounted with the LED, there is a disadvantage that unevenness in light emission is generated between a plurality of the LEDs.

In order to solve such a disadvantage, it has been considered that, for example, a plurality of LEDs are covered with a phosphor layer to fabricate a plurality of phosphor layer-covered LEDs and thereafter, the phosphor layer-covered LED is selected in accordance with the emission wavelength and the luminous efficiency to be then mounted on a board.

For example, a phosphor layer-covered LED (a chip component) obtained by the following method has been proposed (ref: for example, Japanese Unexamined Patent Publication No. 2001-308116).

That is, first, a pressure-sensitive adhesive sheet in which the pressure-sensitive adhesive force is capable of being reduced by application of an ultraviolet ray is attached onto a silica glass substrate and thereafter, a chip (an LED) is attached onto the pressure-sensitive adhesive sheet. Then, a resin is applied onto the chip to fabricate dummy wafers made of the chips covered with the resin on the pressure-sensitive adhesive sheet. Thereafter, an ultraviolet ray is applied from the back side (the lower side) of the silica glass substrate to weaken the pressure-sensitive adhesive force of the pressure-sensitive adhesive sheet and the dummy wafers are peeled from the silica glass substrate and the pressure-sensitive adhesive sheet. Then, the peeled dummy wafers are subjected to dicing on a chip basis to be singulated.

### SUMMARY OF THE INVENTION

In the method described in Japanese Unexamined Patent Publication No. 2001-308116, however, the ultraviolet ray applied from the back side transmits through the silica glass substrate to then reach the pressure-sensitive adhesive sheet, so that it is required to select a board material, which is capable of allowing an ultraviolet ray to transmit therethrough, such as a silica glass substrate as a board. Thus, there is a limit to the selection of a board material.

In the method described in Japanese Unexamined Patent Publication No. 2001-308116, when the dummy wafers are subjected to dicing, the dummy wafers are already peeled from the silica glass substrate and the pressure-sensitive adhesive sheet, that is, the dummy wafers are not supported by the silica glass substrate. Thus, the dummy wafers are not capable of being subjected to dicing with excellent accuracy and as a result, there is a disadvantage that size stability of the chip component to be obtained is low.

It is an object of the present invention to provide a method for producing a phosphor layer-covered LED in which not only using a support board having active energy ray transmissive properties, but also using a support board having active energy ray blocking properties, a phosphor layer-covered LED is capable of being easily obtained with excellent size stability; a phosphor layer-covered LED obtained by the method; and an LED device including the phosphor layer-covered LED.

A method for producing a phosphor layer-covered LED of the present invention includes a preparing step of preparing a support sheet including a hard support board and a pressure-sensitive adhesive layer laminated at one surface in a thickness direction of the support board and having a pressure-sensitive adhesive force capable of being reduced by application of an active energy ray; an LED attaching step of attaching an LED to the support board via the pressure-sensitive adhesive layer; a covering step of disposing a phosphor layer at the one surface in the thickness direction of the support board so as to cover the LED with the phosphor layer; a cutting step of, after the covering step, cutting the phosphor layer corresponding to the LED to produce a phosphor layer-covered LED including the LED and the phosphor layer covering the LED; and an LED peeling step of, after the cutting step, peeling the phosphor layer-covered LED from the pressure-sensitive adhesive layer by applying an active energy ray at least from one side in the thickness direction to the pressure-sensitive adhesive layer.

In the method for producing a phosphor layer-covered LED of the present invention, it is preferable that the phosphor layer is formed of a phosphor sheet.

In the method for producing a phosphor layer-covered LED of the present invention, it is preferable that in the covering step, the LED is covered with the phosphor layer that is in a B-stage state and thereafter, the phosphor layer is cured to be brought into a C-stage state.

In the method for producing a phosphor layer-covered LED of the present invention, it is preferable that the phosphor layer includes a cover portion that covers the LED and a reflector portion that contains a light reflecting component and is formed so as to surround the cover portion.

In the method for producing a phosphor layer-covered LED of the present invention, it is preferable that in the preparing step, the support sheet is prepared so that a reference mark, which serves as a reference of cutting in the cutting step, is provided in advance.

A phosphor layer-covered LED of the present invention is obtained by a method for producing a phosphor layer-covered LED including a preparing step of preparing a support sheet including a hard support board and a pressure-sensitive adhesive layer laminated at one surface in a thickness direction of the support board and having a pressure-sensitive adhesive force capable of being reduced by application of an active energy ray; an LED attaching step of attaching an LED to the support board via the pressure-sensitive adhesive layer; a covering step of disposing a phosphor layer at the one surface in the thickness direction of the support board so as to cover the LED with the phosphor layer; a cutting step of, after the covering step, cutting the phosphor layer corresponding to the LED to produce a phosphor layer-covered LED including the LED and the phosphor layer covering the LED; and an LED peeling step of, after the cutting step, peeling the phosphor layer-covered LED from the pressure-sensitive adhesive layer by applying an active energy ray at least from one side in the thickness direction to the pressure-sensitive adhesive layer.

An LED device of the present invention includes a board and a phosphor layer-covered LED mounted on the board, wherein the phosphor layer-covered LED is obtained by a method for producing a phosphor layer-covered LED including a preparing step of preparing a support sheet including a hard support board and a pressure-sensitive adhesive layer laminated at one surface in a thickness direction of the support board and having a pressure-sensitive adhesive force capable of being reduced by application of an active energy ray; an LED attaching step of attaching an LED to the support board via the pressure-sensitive adhesive layer; a covering step of disposing a phosphor layer at the one surface in the thickness direction of the support board so as to cover the LED with the phosphor layer; a cutting step of, after the covering step, cutting the phosphor layer corresponding to the LED to produce a phosphor layer-covered LED including the LED and the phosphor layer covering the LED; and an LED peeling step of, after the cutting step, peeling the phosphor layer-covered LED from the pressure-sensitive adhesive layer by applying an active energy ray at least from one side in the thickness direction to the pressure-sensitive adhesive layer.

According to the method for producing a phosphor layer-covered LED of the present invention, in the LED peeling step, the active energy ray is applied at least from the one side in the thickness direction to the pressure-sensitive adhesive layer. Then, the active energy ray transmits through the phosphor layer to be applied to the pressure-sensitive adhesive layer. Thus, it is not required to form the support board from a board material that allows the active energy ray to transmit therethrough to then allow the active energy ray to transmit through the support board. As a result, as a support board, not only a support board having active energy ray transmissive properties is used, but also a support board having active energy ray blocking properties is capable of being selected.

After the cutting step, the LED peeling step is performed. That is, in the cutting step, the phosphor sheet is capable of being cut, while the LED and the phosphor sheet are supported by the support sheet including the hard support board. Thus, the phosphor layer-covered LED having excellent size stability can be obtained.

Consequently, the phosphor layer-covered LED of the present invention has excellent size stability.

Also, the LED device of the present invention includes the phosphor layer-covered LED having excellent size stability, so that it has excellent reliability and therefore, its luminous efficiency is improved.

### BRIEF DESCRIPTION OF THE DRAWINGS

FIG. 1 shows process drawings for illustrating a first embodiment of a method for producing a phosphor layer-covered LED of the present invention:
   FIG. 1 (a) illustrating a step of preparing a support sheet (a preparing step),
   FIG. 1 (b) illustrating a step of disposing LEDs on the support sheet (an LED attaching step),
   FIG. 1 (c) illustrating a step of attaching a phosphor sheet to the upper surface of the support sheet (a sheet attaching step),
   FIG. 1 (d) illustrating a step of encapsulating the LEDs by the phosphor sheet (an encapsulating step) and a step of cutting the phosphor sheet (a cutting step),
   FIG. 1 (e) illustrating a step of peeling phosphor layer-covered LEDs from the support sheet (an LED peeling step), and
   FIG. 1 (f) illustrating a step of mounting the phosphor layer-covered LED on a board (a mounting step).
FIG. 2 shows a plan view of the support sheet shown in FIG. 1 (a).
FIG. 3 shows process drawings for illustrating a second embodiment of a method for producing a phosphor layer-covered LED of the present invention:
FIG. 3 (a) illustrating a step of preparing a support sheet (a preparing step),
FIG. 3 (b) illustrating a step of disposing LEDs on the support sheet (an LED attaching step),
FIG. 3 (c) illustrating a step of embedding the LEDs by embedding portions of an embedding-reflector sheet (a sheet attaching step),
FIG. 3 (d) illustrating a step of encapsulating the LEDs by the embedding portions (an encapsulating step) and a step of cutting a reflector portion (a cutting step),
FIG. 3 (e) illustrating a step of peeling phosphor sheet-covered LEDs each including the reflector portion from the support sheet (an LED peeling step), and
FIG. 3 (f) illustrating a step of mounting the phosphor sheet-covered LED including the reflector portion on a board (a mounting step).
FIG. 4 shows a plan view of the phosphor sheet-embedded LEDs shown in FIG. 3 (d).
FIG. 5 shows process drawings for illustrating a method for producing the embedding-reflector sheet shown in FIG. 3 (b):
   FIG. 5 (a) illustrating a step of disposing a reflector sheet on a pressing device,
   FIG. 5 (b) illustrating a step of pressing the reflector sheet to form a reflector portion,
   FIG. 5 (c) illustrating a step of disposing a phosphor sheet on the reflector portion,
   FIG. 5 (d) illustrating a step of pressing the phosphor sheet to form embedding portions,
      and
   FIG. 5 (e) illustrating a step of peeling the embedding-reflector sheet from a releasing sheet.
FIG. 6 shows process drawings for illustrating a method for producing an embedding-reflector sheet used in a third embodiment of a method for producing a phosphor layer-covered LED of the present invention:
   FIG. 6 (a) illustrating a step of disposing a reflector sheet on a pressing device,
   FIG. 6 (b) illustrating a step of pressing the reflector sheet to form a reflector portion,
   FIG. 6 (c) illustrating a step of potting a varnish of a phosphor resin composition into through holes, and
   FIG. 6 (d) illustrating a step of peeling the embedding-reflector sheet from a releasing sheet.
FIG. 7 shows process drawings for illustrating a fourth embodiment of a method for producing a phosphor layer-covered LED of the present invention:
   FIG. 7 (a) illustrating a step of preparing a support sheet (a preparing step),
   FIG. 7 (b) illustrating a step of disposing LEDs on the support sheet (an LED attaching step),
   FIG. 7 (c) illustrating a step of embedding the LEDs by embedding portions of an embedding-reflector sheet (a sheet attaching step),
   FIG. 7 (d) illustrating a step of encapsulating the LEDs by the embedding portions (an encapsulating step) and a step of cutting a reflector portion (a cutting step),
   FIG. 7 (e) illustrating a step of peeling phosphor sheet-covered LEDs each including the reflector portion from the support sheet (an LED peeling step), and
   FIG. 7 (f) illustrating a step of mounting the phosphor sheet-covered LED including the reflector portion on a board (a mounting step).
FIG. 8 shows process drawings for illustrating a fifth embodiment of a method for producing a phosphor layer-covered LED of the present invention:
   FIG. 8 (a) illustrating a step of preparing a support sheet (a preparing step),
   FIG. 8 (b) illustrating a step of disposing LEDs on the support sheet (an LED attaching step),
   FIG. 8 (c) illustrating a step of embedding the LEDs by embedding portions of an embedding-reflector sheet (a sheet attaching step),
   FIG. 8 (d) illustrating a step of encapsulating the LEDs by the embedding portions (an encapsulating step) and a step of cutting a reflector portion (a cutting step),
   FIG. 8 (e) illustrating a step of peeling phosphor sheet-covered LEDs each including the reflector portion from the support sheet (an LED peeling step), and
   FIG. 8 (f) illustrating a step of mounting the phosphor sheet-covered LED including the reflector portion on a board (a mounting step).
FIG. 9 shows process drawings for illustrating a method for producing the embedding-reflector sheet shown in FIG. 8 (b):
   FIG. 9 (a) illustrating a step of disposing a reflector sheet on a punching device,
   FIG. 9 (b) illustrating a step of stamping out the reflector sheet to form a reflector portion,
   FIG. 9 (c) illustrating a step of disposing a phosphor sheet on the reflector portion,
   FIG. 9 (d) illustrating a step of pressing the phosphor sheet to form embedding portions,
      and
   FIG. 9 (e) illustrating a step of peeling the embedding-reflector sheet from a releasing sheet.
FIG. 10 shows process drawings for illustrating a method for producing an embedding-reflector sheet used in a sixth embodiment of a method for producing a phosphor layer-covered LED of the present invention:
   FIG. 10 (a) illustrating a step of disposing a reflector sheet on a punching device,
   FIG. 10 (b) illustrating a step of stamping out the reflector sheet to form a reflector portion,
   FIG. 10 (c) illustrating a step of potting a varnish of a phosphor resin composition into through holes, and
   FIG. 10 (d) illustrating a step of peeling the embedding-reflector sheet from a releasing sheet.
FIG. 11 shows process drawings for illustrating a seventh embodiment of a method for producing a phosphor layer-covered LED of the present invention:
   FIG. 11 (a) illustrating a step of preparing a support sheet (a preparing step),
   FIG. 11 (b) illustrating a step of disposing LEDs on the support sheet (an LED attaching step),
   FIG. 11 (c) illustrating a step of covering the LEDs with cover portions (a covering step),
   FIG. 11 (d) illustrating a step of curing the cover portions (a curing step) and a step of cutting a reflector portion (a cutting step),
   FIG. 11 (e) illustrating a step of peeling phosphor sheet-covered LEDs each including the reflector portion from the support sheet (an LED peeling step), and
   FIG. 11 (f) illustrating a step of mounting the phosphor sheet-covered LED including the reflector portion on a board (a mounting step).
FIG. 12 shows process drawings for illustrating an eighth embodiment of a method for producing a phosphor layer-covered LED of the present invention:
   FIG. 12 (a) illustrating a step of preparing a support sheet (a preparing step),
   FIG. 12 (b) illustrating a step of disposing LEDs on the support sheet (an LED attaching step),
   FIG. 12 (c) illustrating a step of covering the side surfaces of the LEDs with a phosphor sheet (a sheet attaching step),
   FIG. 12 (d) illustrating a step of curing the phosphor sheet (a curing step) and a step of cutting the phosphor sheet (a cutting step),
   FIG. 12 (e) illustrating a step of peeling phosphor sheet-covered LEDs from the support sheet (an LED peeling step), and
   FIG. 12 (f) illustrating a step of mounting the phosphor sheet-covered LED on a board (a mounting step).
FIG. 13 shows a perspective view of a dispenser used in a ninth embodiment of a method for producing a phosphor layer-covered LED of the present invention.

### DETAILED DESCRIPTION OF THE INVENTION

<First Embodiment>

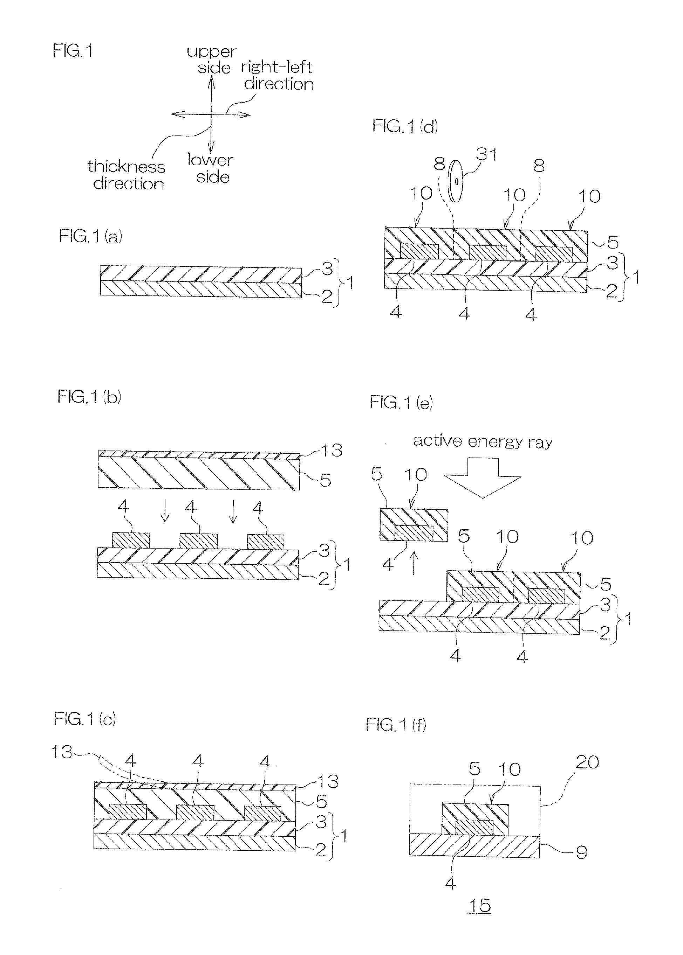

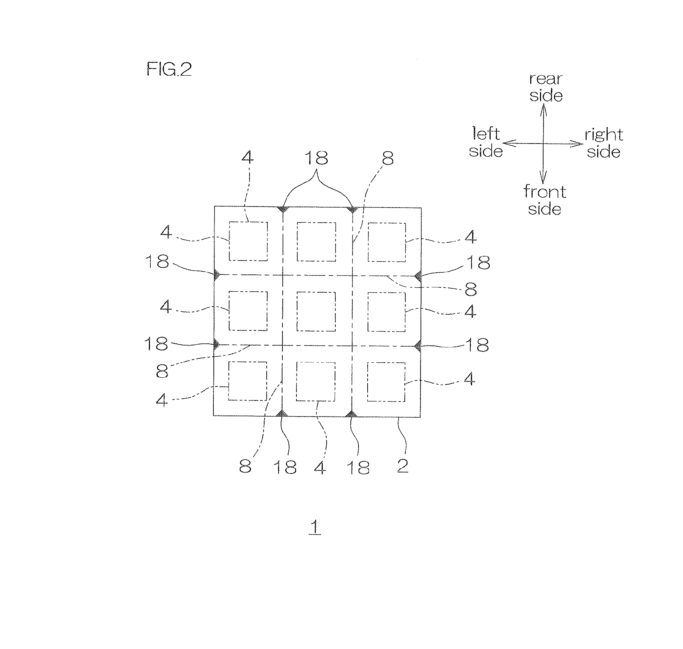

In FIG. 1, the up-down direction of the paper surface is referred to as an up-down direction (a first direction, a thickness direction); the right-left direction of the paper surface is referred to as a right-left direction (a second direction, a direction perpendicular to the first direction); and the paper thickness direction of the paper is referred to as a front-rear direction (a third direction, a direction perpendicular to the first direction and the second direction). Directions and direction arrows in FIG. 2 and the subsequent figures are in conformity with the above-described directions and the direction arrows in FIG. 1.

FIG. 1 shows process drawings for illustrating a first embodiment of a method for producing a phosphor layer-covered LED of the present invention. FIG. 2 shows a plan view of the support sheet shown in FIG. 1 (a).

In FIG. 2, a pressure-sensitive adhesive layer 3 to be described later is omitted so as to clearly show the relative arrangement of a support board 2 and a reference mark 18 to be described later.

A method for producing a phosphor sheet-covered LED 10 that is one example of a phosphor layer-covered LED includes the steps of preparing a support sheet 1 (ref: FIG. 1 (a)) (a preparing step); attaching LEDs 4 to the support board 2 via the pressure-sensitive adhesive layer 3 (ref: FIG. 1 (b)) (an LED attaching step); encapsulating the LEDs 4 by a phosphor sheet 5 as a phosphor layer (one example of a covering step, ref: FIGS. 1 (c) and 1 (d)) (an encapsulating step); cutting the phosphor sheet 5 corresponding to each of the LEDs 4 (ref: dashed lines in FIG. 1 (d)) (a cutting step); and peeling the phosphor sheet-covered LEDs 10 from the pressure-sensitive adhesive layer 3 (ref: FIG. 1 (e)) (an LED peeling step).

In the following, the steps are described in detail.

<Preparing Step>

As shown in FIGS. 1 (a) and 2, the support sheet 1 is formed into a sheet shape extending in the plane direction (a direction perpendicular to the thickness direction, that is, the right-left direction and the front-rear direction). The support sheet 1 is formed into, for example, a rectangular shape in plane view (a shape when projected in the thickness direction).

The support sheet 1 is prepared so that the reference marks 18, which serve as a reference of cutting in the cutting step (ref: the dashed lines in FIG. 1 (d)) to be described later, are provided in advance.

As shown in FIG. 2, a plurality of the reference marks 18 are provided at spaced intervals to each other at the circumference end portion in the plane direction of the support sheet 1. The reference marks 18 are, for example, provided at two sides that are opposed to each other in the support sheet 1. The reference marks 18 are formed to make a pair opposing to each other in an opposing direction of the two sides of the support sheet 1. One pair of the reference marks 18 is provided corresponding to the LEDs 4 (ref: phantom lines in FIG. 2) that are subsequently disposed and is disposed so as to be capable of singulating the LEDs 4 when the phosphor sheet 5 is cut with the reference marks 18 as a reference.

Each of the reference marks 18 is formed into a shape that is easily recognized in plane view and is, for example, formed into a generally triangular shape in plane view.

In a size of the support sheet 1, the maximum length thereof is, for example, 10 mm or more and 300 mm or less and the length of one side thereof is, for example, 10 mm or more and 300 mm or less.

The support sheet 1 is configured to be capable of supporting the LEDs 4 (ref: FIG. 1 (b)) to be described next and includes, for example, the support board 2 and the pressure-sensitive adhesive layer 3 that is laminated on the upper surface of the support board 2.

The support board 2 is incapable of stretching at least in the plane direction and is formed of a hard material. The material is not particularly limited as long as its hardness properties are secured. The material is appropriately selected from, for example, an active energy ray blocking material that blocks an active energy ray, an active energy ray transmissive material that allows an active energy ray to transmit therethrough, and furthermore, an active energy ray semi-transmissive material that allows an active energy ray to partially transmit (semi-transmit) therethrough. To be specific, examples of the material for forming the support board 2 include an oxide such as a silicon oxide (silica or the like) and alumina, a metal such as stainless steel, and silicon.

The support board 2 has a Young's modulus at 23°C of, for example, 1 × 10⁶ Pa or more, preferably 1 × 10⁷ Pa or more, or more preferably 1 × 10⁸ Pa or more, and of, for example, 1 × 10¹² Pa or less. When the Young's modulus of the support board 2 is not less than the above-described lower limit, hardness of the support board 2 is secured and the LEDs 4 (ref: FIG. 1 (b)) to be described later can be surely supported. The Young's modulus of the support board 2 is obtained by, for example, the compressive elastic modulus in JIS H 7902:2008.

The thickness of the support board 2 is, for example, 0.1 mm or more, or preferably 0.3 mm or more, and is, for example, 5 mm or less, or preferably 2 mm or less.

As shown in FIG. 1 (a), the pressure-sensitive adhesive layer 3 is formed on the entire upper surface of the support board 2.

The pressure-sensitive adhesive layer 3 is formed from a material in which the pressure-sensitive adhesive force is capable of being reduced by application of an active energy ray as an active energy ray irradiation release layer (sheet). To be specific, an example of the pressure-sensitive adhesive layer 3 includes a pressure-sensitive adhesive layer such as an acrylic pressure-sensitive adhesive layer. The pressure-sensitive adhesive layer 3 can be also formed of, for example, an active energy ray irradiation release layer (sheet) described in Japanese Unexamined Patent Publication No. 2001-308116.

The thickness of the pressure-sensitive adhesive layer 3 is, for example, 0.1 mm or more, or preferably 0.2 mm or more, and is, for example, 1 mm or less, or preferably 0.5 mm or less.

In order to prepare the support sheet 1, for example, the support board 2 is attached to the pressure-sensitive adhesive layer 3. Also, the pressure-sensitive adhesive layer 3 can be directly laminated on the support board 2 by an application method or the like in which first, the support board 2 is prepared; next, a varnish prepared from the above-described pressure-sensitive adhesive material and a solvent blended as required is applied to the support board 2; and thereafter, the solvent is distilled off as required.

The thickness of the support sheet 1 is, for example, 0.2 mm or more, or preferably 0.5 mm or more, and is, for example, 6 mm or less, or preferably 2.5 mm or less.

<LED Attaching Step>

The LED attaching step is performed after the preparing step.

As shown by the lower portion in FIG. 1 (b) and by the phantom lines in FIG. 2, each of the LEDs 4 is, for example, formed into a generally rectangular shape in sectional view and a generally rectangular shape in plane view with the thickness shorter than the length (the maximum length) in the plane direction (a direction perpendicular to the thickness direction). The lower surface of each of the LEDs 4 is formed of a bump that is not shown. An example of the LEDs 4 includes blue light emitting diode elements that emit blue light.

The maximum length in the plane direction of each of the LEDs 4 is, for example, 0.1 mm or more and 3 mm or less. The thickness thereof is, for example, 0.05 mm or more and 1 mm or less.

In the LED attaching step, for example, a plurality of the LEDs 4 are attached in alignment onto the upper surface of the pressure-sensitive adhesive layer 3. To be specific, a plurality of the LEDs 4 are attached onto the upper surface of the pressure-sensitive adhesive layer 3 in such a manner that a plurality of the LEDs 4 are arranged at equal intervals to each other in the front-rear and the right-left directions in plane view. The LEDs 4 are attached onto the upper surface of the pressure-sensitive adhesive layer 3 so that bumps thereof that are not shown are opposed to the upper surface of the pressure-sensitive adhesive layer 3. In this way, the LEDs 4 are supported at (pressure-sensitively adhere to) the upper surface of the pressure-sensitive adhesive layer 3 so that the alignment state thereof is retained.

The gap between the LEDs 4 is, for example, 0.05 mm or more and 2 mm or less.

<Encapsulating Step>

The encapsulating step is performed after the LED attaching step.

In the upper portion in FIG. 1 (b), the phosphor sheet 5 is formed from a phosphor resin composition containing a curable resin and a phosphor into a sheet shape extending in the plane direction.

Examples of the curable resin include a thermosetting resin that is cured by heating and an active energy ray curable resin that is cured by application of an active energy ray (for example, an ultraviolet ray and an electron beam). Preferably, a thermosetting resin is used.

To be specific, an example of the curable resin includes a thermosetting resin such as a silicone resin, an epoxy resin, a polyimide resin, a phenol resin, a urea resin, a melamine resin, and an unsaturated polyester resin. Preferably, a silicone resin is used.

An example of the silicone resin includes a silicone resin such as a two-step curable type silicone resin and a one-step curable type silicone resin. Preferably, a two-step curable type silicone resin is used.

The two-step curable type silicone resin is a thermosetting silicone resin that has a two-step reaction mechanism and in which a silicone resin is brought into a B-stage state (a semi-cured state) in the first-step reaction and is brought into a C-stage state (a final cured state) in the second-step reaction. On the other hand, the one-step curable type silicone resin is a thermosetting silicone resin that has a one-step reaction mechanism and in which a silicone resin is completely cured in the first-step reaction.

The B-stage state is a state between an A-stage state in which a thermosetting silicone resin is in a liquid state and a C-stage state in which the thermosetting silicone resin is completely cured. Also, the B-stage state is a state in which the curing and the gelation of the thermosetting silicone resin are slightly progressed and the compressive elastic modulus thereof is smaller than the elastic modulus thereof in a C-stage state.

An example of the two-step curable type silicone resin includes a condensation reaction and addition reaction curable type silicone resin that has two reaction systems of a condensation reaction and an addition reaction.

The mixing ratio of the curable resin with respect to the phosphor resin composition is, for example, 30 mass % or more, or preferably 50 mass % or more, and is, for example, 99 mass % or less, or preferably 95 mass % or less.

The phosphor has a wavelength conversion function and examples thereof include a yellow phosphor that is capable of converting blue light into yellow light and a red phosphor that is capable of converting blue light into red light.

Examples of the yellow phosphor include a garnet type phosphor having a garnet type crystal structure such as Y₃Al₅O₁₂:Ce (YAG (yttrium aluminum garnet):Ce) and Tb₃Al₃O₁₂:Ce (TAG (terbium aluminum garnet):Ce) and an oxynitride phosphor such as Ca-α-SiAlON.

An example of the red phosphor includes a nitride phosphor such as CaAlSiN₃:Eu and CaSiN₂:Eu.

Preferably, a yellow phosphor is used.

Examples of a shape of the phosphor include a sphere shape, a plate shape, and a needle shape. Preferably, in view of fluidity, a sphere shape is used.

The average value of the maximum length (in the case of a sphere shape, the average particle size) of the phosphor is, for example, 0.1 µm or more, or preferably 1 µm or more, and is, for example, 200 µm or less, or preferably 100 µm or less.

The mixing ratio of the phosphor with respect to 100 parts by mass of the curable resin is, for example, 0.1 parts by mass or more, or preferably 0.5 parts by mass or more, and is, for example, 80 parts by mass or less, or preferably 50 parts by mass or less.

Furthermore, the phosphor resin composition can also contain a filler.

Examples of the filler include organic microparticles such as silicone particles and inorganic microparticles such as silica, talc, alumina, aluminum nitride, and silicon nitride. The mixing ratio of the filler with respect to 100 parts by mass of the curable resin is, for example, 0.1 parts by mass or more, or preferably 0.5 parts by mass or more, and is, for example, 70 parts by mass or less, or preferably 50 parts by mass or less.

As shown in FIG. 1 (c), in order to attach the phosphor sheet 5 to the support board 2 via the pressure-sensitive adhesive layer 3, first, as shown by the upper portion in FIG. 1 (b), the phosphor sheet 5 is prepared. In order to prepare the phosphor sheet 5, a curable resin and a phosphor, and a filler, which is blended as required, are blended to prepare a phosphor resin composition. Next, the phosphor resin composition is applied to the surface of a release sheet 13 to be then heated. Examples of the release sheet 13 include a polymer film such as a polyethylene film and a polyester film (PET or the like), a ceramic sheet, and a metal foil. Preferably, a polymer film is used. The surface of the release sheet 13 can be also subjected to release treatment such as fluorine treatment.

When the curable resin contains a two-step curable type silicone resin, the curable resin is brought into a B-stage state (a semi-cured state) by the above-described heating. That is, the phosphor sheet 5 in a B-stage state is prepared.

The phosphor sheet 5 has a compressive elastic modulus at 23°C of, for example, 0.01 MPa or more, or preferably 0.04 MPa or more, and of, for example, 1.0 MPa or less.

When the compressive elastic modulus of the phosphor sheet 5 is not more than the above-described upper limit, sufficient flexibility can be secured. On the other hand, when the compressive elastic modulus of the phosphor sheet 5 is not less than the above-described lower limit, the LEDs 4 can be embedded.

Next, as shown in FIG. 1 (c), the phosphor sheet 5 is disposed on the upper surface of the pressure-sensitive adhesive layer 3 so as to embed the LEDs 4 (an embedding step). That is, the phosphor sheet 5 is disposed on the support sheet 1 so as to cover the upper surfaces and the side surfaces of the LEDs 4.

To be specific, as shown by arrows in FIG. 1 (b), the phosphor sheet 5 laminated on the release sheet 13 is compressively bonded toward the pressure-sensitive adhesive layer 3.

In this way, the side surfaces and the upper surfaces of the LEDs 4, and a portion of the upper surface of the pressure-sensitive adhesive layer 3 that is exposed from the LEDs 4 are covered with the phosphor sheet 5 in close contact with each other.

That is, in the encapsulating step, the embedding step in which the LEDs 4 are embedded by the phosphor sheet 5 is performed.

Thereafter, as shown by the phantom line in FIG. 1 (c), the release sheet 13 is peeled from the upper surface of the phosphor sheet 5.

Thereafter, as shown in FIG. 1 (d), the phosphor sheet 5 is cured. When the curable resin is a thermosetting resin, the phosphor sheet 5 is thermally cured. To be specific, the phosphor sheet 5 is heated at, for example, 80°C or more, or preferably 100°C or more, and at, for example, 200°C or less, or preferably 180°C or less.

When the thermosetting resin contains a two-step curable type silicone resin and when the phosphor sheet 5 that embeds the LEDs 4 is in a B-stage state, the phosphor sheet 5 is completely cured (subjected to a final curing) to be brought into a C-stage state by the above-described heating.

When the thermosetting resin contains a one-step curable type silicone resin, the phosphor sheet 5 is completely cured (subjected to a final curing) to be brought into a C-stage state by the above-described heating.

When the curable resin is an active energy ray curable resin, an active energy ray is applied to the phosphor sheet 5 from the upper side. When the active energy ray is applied from the upper side, the curable resin and the irradiation conditions are selected so as not to reduce the pressure-sensitive adhesive force of the pressure-sensitive adhesive layer 3 by the application of the active energy ray.

The cured (completely cured) phosphor sheet 5 has flexibility. To be specific, the cured (completely cured) phosphor sheet 5 has a compressive elastic modulus at 23°C of, for example, 0.5 MPa or more, or preferably 1.0 MPa or more, and of, for example, 100 MPa or less, or preferably 10 MPa or less. When the compressive elastic modulus of the phosphor sheet 5 is not more than the above-described upper limit, the flexibility can be surely secured and in the cutting step (ref: FIG. 1 (d)) to be described next, for example, the phosphor sheet 5 can be cut using a cutting device (described later). When the compressive elastic modulus of the phosphor sheet 5 is not less than the above-described lower limit, the shape thereof after being cut can be retained.

The phosphor sheet 5 has a light transmittance at the wavelength of 400 nm or less of, for example, 50 % or more, or preferably 60 % or more. When the light transmittance of the phosphor sheet 5 is not less than the above-described lower limit, the light transmission properties of the active energy ray in the phosphor sheet 5 are surely secured and the active energy ray can transmit through the phosphor sheet 5 to reach the pressure-sensitive adhesive layer 3. At the same time, an LED device 15 (described later) having excellent brightness can be obtained.

In this way, the side surfaces and the upper surfaces of the LEDs 4, and a portion of the upper surface of the pressure-sensitive adhesive layer 3 that is exposed from the LEDs 4 are covered with the phosphor sheet 5 in close contact with each other. That is, the LEDs 4 are encapsulated by the phosphor sheet 5 in a C-stage state.

<Cutting Step>

After the encapsulating step, as shown by the dashed lines in FIG. 1 (d), in the cutting step, the phosphor sheet 5 around the LEDs 4 is cut along the thickness direction. As shown by dash-dot lines in FIG. 2, for example, the phosphor sheet 5 is cut into a generally rectangular shape in plane view that surrounds each of the LEDs 4.

In order to cut the phosphor sheet 5, for example, a dicing device using a disc-shaped dicing saw (dicing blade) 31, a cutting device using a cutter, a laser irradiation device, or the like is used.

The cutting of the phosphor sheet 5 is performed with the reference marks 18 as a reference. To be specific, the phosphor sheet 5 is cut so as to form cuts 8 along the straight lines (shown by the dash-dot lines in FIG. 2) that connect the reference marks 18 making one pair.

In the cutting of the phosphor sheet 5, the phosphor sheet 5 is cut from the upper surface toward the lower surface so that, for example, the cuts 8 fail to pass through the support sheet 1, preferably, the cuts 8 fail to pass through the pressure-sensitive adhesive layer 3.

By the cutting step, the phosphor sheet-covered LEDs 10, each of which includes the LED 4 and the phosphor sheet 5 that is cut so as to cover the surfaces (the upper surface and the side surfaces) of the LED 4, are obtained in a state of being in close contact with the support sheet 1. That is, the phosphor sheets 5 are singulated corresponding to the LEDs 4.

<LED Peeling Step>

After the cutting step, in FIG. 1 (e), in the LED peeling step, each of the phosphor sheet-covered LEDs 10 is peeled from the upper surface of the pressure-sensitive adhesive layer 3.

In order to peel each of the phosphor sheet-covered LEDs 10 from the upper surface of the pressure-sensitive adhesive layer 3, first, as shown by a down arrow in FIG. 1 (e), an active energy ray is applied from the upper side (one side in the thickness direction) to the pressure-sensitive adhesive layer 3 via the phosphor sheet 5.

Examples of the active energy ray include an ultraviolet ray and an electron beam. An example of the active energy ray also includes an active energy ray having a spectral distribution in a wavelength region of, for example, 180 nm or more, or preferably 200 nm or more, and of, for example, 460 nm or less, or preferably 400 nm or less.

In the application of the active energy ray, an application device is used. Examples thereof include a chemical lamp, an excimer laser, a black light, a mercury arc, a carbon arc, a low pressure mercury lamp, a medium pressure mercury lamp, a high pressure mercury lamp, an extra-high pressure mercury lamp, and a metal halide lamp. Also, an example thereof includes an application device capable of generating an active energy ray that is in the longer wavelength side or in the shorter wavelength side than in the above-described wavelength region.

The amount of irradiation is, for example, 0.001 J/cm² or more, or preferably 0.01 J/cm² or more, and is, for example, 100 J/cm² or less, or preferably 10 J/cm² or less. When the amount of irradiation is not less than the above-described lower limit, the pressure-sensitive adhesive force of the pressure-sensitive adhesive layer 3 can be surely and efficiently reduced. On the other hand, when the amount of irradiation is not more than the above-described upper limit, an increase in cost can be suppressed and a damage to a device can be effectively prevented.

The irradiation duration is, for example, 10 minutes or less, or preferably 1 minute or less, and is, for example, 5 seconds or more. When the upper limit of the irradiation duration is not more than the above-described upper limit, a duration required for peeling the LEDs 4 can be shortened.

All or a part of the active energy ray transmits through the phosphor sheet 5 from the upper side to be applied to the pressure-sensitive adhesive layer 3.

By the application of the active energy ray, the pressure-sensitive adhesive force of the pressure-sensitive adhesive layer 3 is reduced.

In this state, as shown by an up arrow in FIG. 1 (e), each of the phosphor sheet-covered LEDs 10 is peeled from the pressure-sensitive adhesive layer 3. In order to peel the phosphor sheet-covered LED 10 from the pressure-sensitive adhesive layer 3, though not shown, a pick-up device that is provided with an absorbing member such as a collet can be used as required. To be specific, the phosphor sheet-covered LED 10 can be peeled from the pressure-sensitive adhesive layer 3, while being absorbed by an absorbing member.

In this way, each of the phosphor sheet-covered LEDs 10 that is peeled from the pressure-sensitive adhesive layer 3 is obtained.

[Mounting Step]

After the LED peeling step, after the phosphor sheet-covered LED 10 is selected in accordance with emission wavelength and luminous efficiency, as shown in FIG. 1 (f), the selected phosphor sheet-covered LED 10 is mounted on a board 9. In this way, the LED device 15 is obtained.

To be specific, the phosphor sheet-covered LED 10 is disposed in opposed relation to the board 9 so that a bump (not shown) in the LED 4 is opposed to a terminal (not shown) provided on the upper surface of the board 9. That is, the LED 4 in the phosphor sheet-covered LED 10 is flip-chip mounted on the board 9.

In this way, the LED device 15 including the board 9 and the phosphor sheet-covered LED 10 that is mounted on the board 9 is obtained.

Thereafter, as shown by the phantom line in FIG. 1 (f), an encapsulating protective layer 20 that encapsulates the phosphor sheet-covered LED 10 is provided in the LED device 15 as required. In this way, reliability of the LED device 15 can be improved.

According to this method, in the LED peeling step, an active energy ray is applied from the upper side to the pressure-sensitive adhesive layer 3 via the phosphor sheet 5. Then, the active energy ray transmits through the phosphor sheet 5 to be applied to the pressure-sensitive adhesive layer 3. Thus, it is not required to form the support board 2 from a board material that allows an active energy ray to transmit therethrough to then allow the active energy ray to transmit through the support board 2. As a result, as the support board 2, not only a support board having active energy ray transmissive properties is used, but also a support board having active energy ray blocking properties is capable of being selected.

After the cutting step, the LED peeling step is performed. That is, in the cutting step, the phosphor sheet 5 is capable of being cut, while the LEDs 4 and the phosphor sheet 5 are supported by the support sheet 1 including the hard support board 2. Thus, the phosphor sheet-covered LED 10 having excellent size stability can be obtained.

Furthermore, in this method, an active energy ray is applied to the pressure-sensitive adhesive layer 3 in the LED peeling step, so that deformation of the support sheet 1 caused by heating is prevented and the size stability can be further improved, compared to a method in which the pressure-sensitive adhesive force of the pressure-sensitive adhesive layer 3 is reduced by heating of the pressure-sensitive adhesive layer 3.

Consequently, the phosphor sheet-covered LED 10 has excellent size stability.

Also, the LED device 15 includes the phosphor sheet-covered LED 10 having excellent size stability, so that it has excellent reliability and thus, its luminous efficiency is improved.

<Modified Example>

In the LED peeling step in FIG. 1 (e) in the first embodiment, an active energy ray is applied from the upper side (one side in the thickness direction) only to the pressure-sensitive adhesive layer 3. However, in the present invention, an active energy ray may be applied at least from the upper side (one side in the thickness direction). For example, when the support board 2 is formed from an active energy ray transmissive material or an active energy ray semi-transmissive material, an active energy ray can be also applied from both of the upper side and the lower side (one side and the other side in the thickness direction) to the pressure-sensitive adhesive layer 3. In such a case, of the active energy ray applied from the lower side of the support sheet 1, all or a part of the active energy ray transmits through the support board 2 to reach the pressure-sensitive adhesive layer 3.

According to the modified example, in the LED peeling step, a duration required for reducing the pressure-sensitive adhesive force of the pressure-sensitive adhesive layer 3, that is, the irradiation duration of an active energy ray can be further shortened and the production efficiency of the phosphor sheet-covered LED 10 can be improved.

In FIG. 2, each of the reference marks 18 is formed into a generally triangular shape in plane view. However, the shape thereof is not particularly limited and can be formed into an appropriate shape such as a generally circular shape in plane view, a generally rectangular shape in plane view, a generally X-shape in plane view, and a generally T-shape in plane view.

<Second Embodiment>

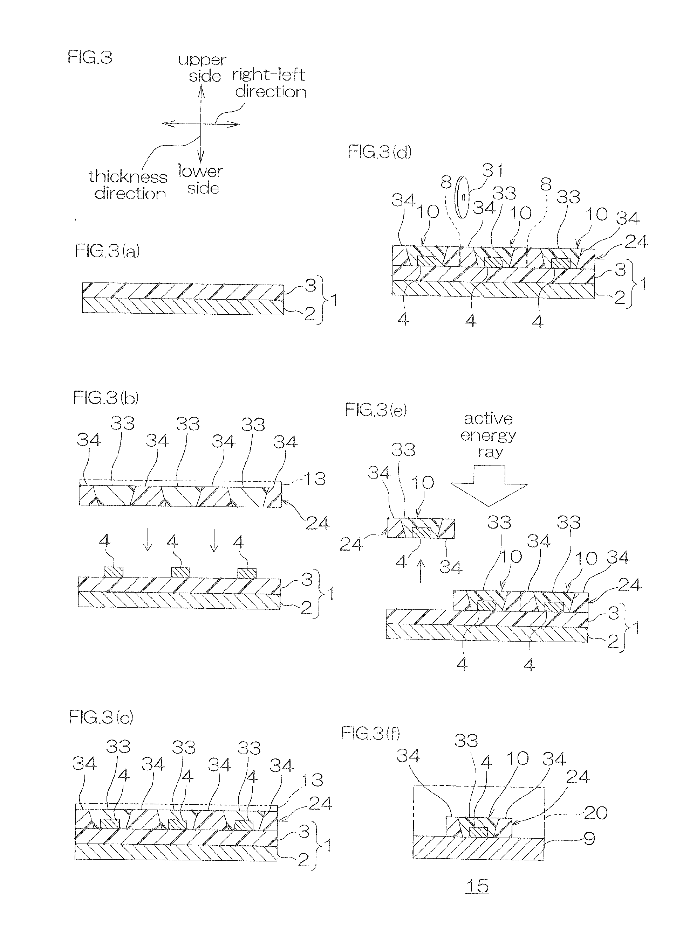

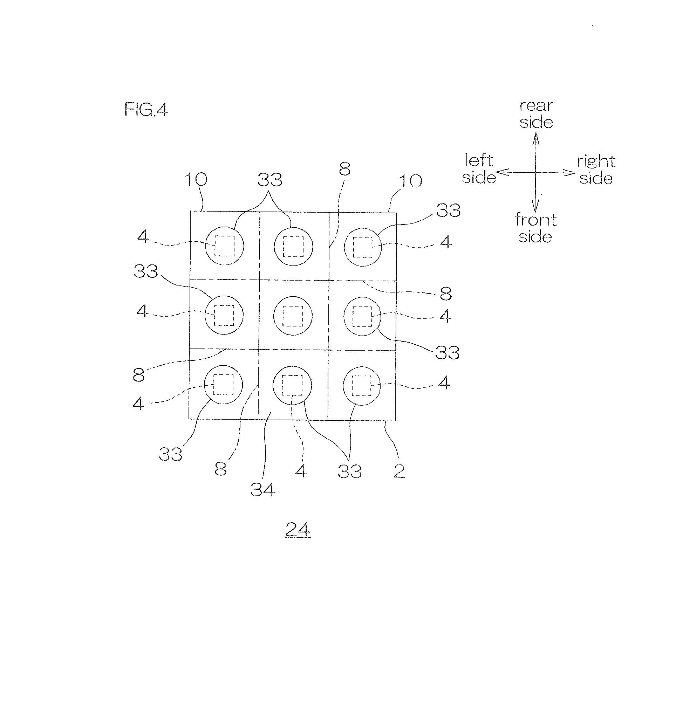

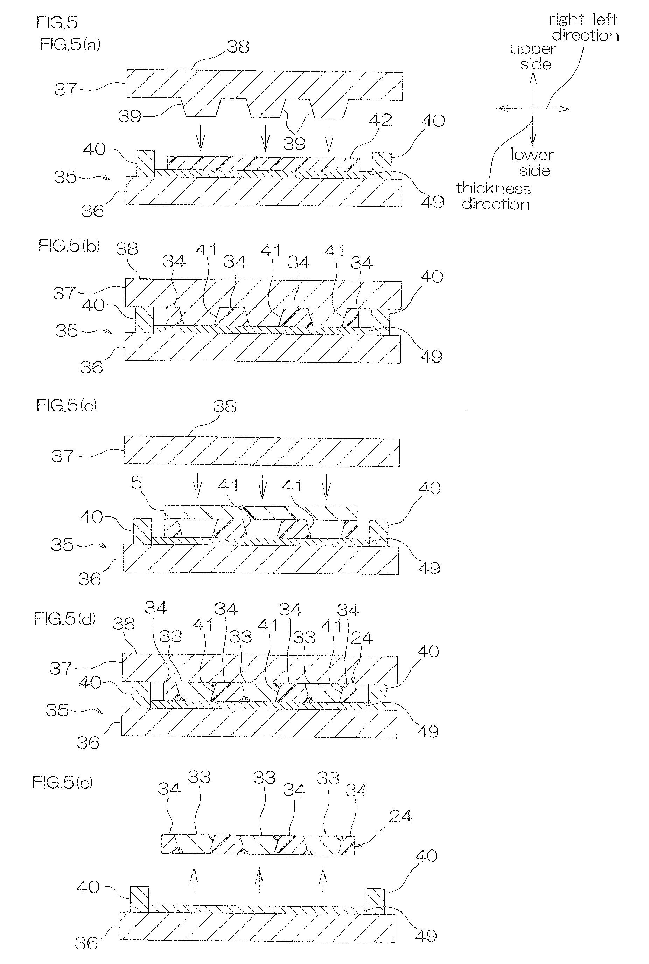

FIG. 3 shows process drawings for illustrating a second embodiment of a method for producing a phosphor layer-covered LED of the present invention. FIG. 4 shows a plan view of the phosphor sheet-embedded LEDs shown in FIG. 3 (d). FIG. 5 shows process drawings for illustrating a method for producing the embedding-reflector sheet shown in FIG. 3 (b).

In the second embodiment, the same reference numerals are provided for members and steps corresponding to each of those in the first embodiment, and their detailed description is omitted.

In the first embodiment, as shown in FIG. 1 (b), the phosphor sheet 5 in which a phosphor is uniformly (uniformly at least in the plane direction) dispersed is illustrated as one example of the phosphor layer of the present invention. Alternatively, for example, as shown in FIGS. 3 (b) and 4, an embedding-reflector sheet 24 that includes embedding portions 33 containing a phosphor as cover portions and a reflector portion 34 surrounding the embedding portions 33 can be also illustrated.

As shown in FIG. 4, a plurality of the embedding portions 33 are provided at spaced intervals to each other as portions that embed a plurality of the LEDs 4 in the embedding-reflector sheet 24. Each of the embedding portions 33 is formed into a generally circular shape in plane view. To be specific, as shown in FIG. 3 (b), each of the embedding portions 33 is formed into a generally conical trapezoidal shape in which its width is gradually reduced toward the lower side.

The diameter (the maximum length) of the lower end portion of each of the embedding portions 33 is larger than the maximum length in the plane direction of each of the LEDs 4. To be specific, the diameter (the maximum length) of the lower end portion thereof with respect to the maximum length in the plane direction of each of the LEDs 4 is, for example, 200 % or more, preferably 300 % or more, or more preferably 500 % or more, and is, for example, 3000 % or less. To be more specific, the diameter (the maximum length) of the lower end portion of each of the embedding portions 33 is, for example, 5 mm or more, or preferably 7 mm or more, and is, for example, 300 mm or less, or preferably 200 mm or less.

The diameter (the maximum length) of the upper end portion of each of the embedding portions 33 is larger than the diameter (the maximum length) of the lower end portion thereof. To be specific, the diameter (the maximum length) of the upper end portion thereof is, for example, 7 mm or more, or preferably 10 mm or more, and is, for example, 400 mm or less, or preferably 250 mm or less.

The gap between the embedding portions 33 (the minimum gap, to be specific, the gap between the upper end portions of the embedding portions 33) is, for example, 20 mm or more, or preferably 50 mm or more, and is, for example, 1000 mm or less, or preferably 200 mm or less.

The embedding portions 33 are formed from the above-described phosphor resin composition. When the phosphor resin composition contains a curable resin, the embedding portions 33 are formed in a B-stage state.

As shown in FIG. 4, the reflector portion 34 is continuous at the circumference end portion of the embedding-reflector sheet 24 and is disposed between the embedding portions 33. The reflector portion 34 is formed into a generally grid shape in plane view surrounding each of the embedding portions 33.

The reflector portion 34 is formed from a reflecting resin composition containing a light reflecting component to be described later.

Next, a method for producing the embedding-reflector sheet 24 is described with reference to FIGS. 4 and 5.

In this method, first, as shown in FIG. 5 (a), a pressing device 35 its prepared.

The pressing device 35 is provided with a support board 36 and a die 37 that is disposed in opposed relation to the upper side of the support board 36.

The support board 36 is, for example, formed of a metal such as stainless steel into a generally rectangular flat plate shape.

The die 37 is, for example, formed of a metal such as stainless steel and integrally includes a flat plate portion 38 and extruded portions 39 that are formed to be extruded downwardly from the flat plate portion 38.

The flat plate portion 38 is formed into the same shape as that of the support board 36 in plane view.

In the die 37, a plurality of the extruded portions 39 are disposed at spaced intervals to each other in the plane direction so as to correspond to the embedding portions 33. That is, each of the extruded portions 39 is formed into a generally conical trapezoidal shape in which its width is gradually reduced from the lower surface of the flat plate portion 38 toward the lower side. To be specific, each of the extruded portions 39 is formed into a tapered shape in which its width is gradually reduced toward the lower side in front sectional view and side sectional view. That is, each of the extruded portions 39 is formed into the same shape as that of each of the embedding portions 33.

As shown in FIG. 5 (a), a spacer 40 is provided on the upper surface of the circumference end portion of the support board 36. The spacer 40 is, for example, formed of a metal such as stainless steel and is disposed so as to surround a plurality of the embedding portions 33 when projected in the thickness direction. The spacer 40 is disposed on the support board 36 so as to be included in the die 37, to be specific, to be overlapped with the circumference end portion of the flat plate portion 38, when projected in the thickness direction.

The thickness of the spacer 40 is set so as to be the total thickness of the thickness of a releasing sheet 49 to be described later and that of each of the extruded portions 39. To be specific, the thickness of the spacer 40 is, for example, 0.3 mm or more, or preferably 0.5 mm or more, and is, for example, 5 mm or less, or preferably 3 mm or less.

In the pressing device 35, the die 37 is configured to be replaceable with that having a different shape. To be specific, in the pressing device 35, the die 37 having the extruded portions 39 shown in FIG. 5 (a) is configured to be replaceable with the die 37 in a flat plate shape having no extruded portion 39 shown in FIG. 5 (c) to be described later.

As shown in FIG. 5 (a), the releasing sheet 49 is disposed at the inner side of the spacer 40 on the upper surface of the support board 36. The circumference end surfaces of the releasing sheet 49 are, on the upper surface of the support board 36, formed so as to be in contact with the inner side surfaces of the spacer 40. The thickness of the releasing sheet 49 is, for example, 10 µm or more, or preferably 30 µm or more, and is, for example, 200 µm or less, or preferably 150 µm or less.

Next, in the pressing device 35 shown in FIG. 5 (a), a reflector sheet 42 is disposed on the upper surface of the releasing sheet 49.

In order to dispose the reflector sheet 42 on the upper surface of the releasing sheet 49, for example, the following method is used: that is, a laminating method in which the reflector sheet 42 formed from a reflecting resin composition is laminated on the upper surface of the releasing sheet 49 or an application method in which a liquid reflecting resin composition is applied to the upper surface of the releasing sheet 49.

The reflecting resin composition contains, for example, a resin and a light reflecting component.

An example of the resin includes a thermosetting resin such as a thermosetting silicone resin, an epoxy resin, a thermosetting polyimide resin, a phenol resin, a urea resin, a melamine resin, an unsaturated polyester resin, a diallyl phthalate resin, and a thermosetting urethane resin. Preferably, a thermosetting silicone resin and an epoxy resin are used.

The light reflecting component is, for example, a white compound. To be specific, an example of the white compound includes a white pigment.

An example of the white pigment includes a white inorganic pigment. Examples of the white inorganic pigment include an oxide such as a titanium oxide, a zinc oxide, and a zirconium oxide; a carbonate such as white lead (lead carbonate) and calcium carbonate; and a clay mineral such as kaolin (kaolinite).

As the white inorganic pigment, preferably, an oxide is used, or more preferably, a titanium oxide is used.

To be specific, the titanium oxide is TiO₂ (titanium oxide (IV), titanium dioxide).

A crystal structure of the titanium oxide is not particularly limited. Examples of the crystal structure thereof include a rutile type, a brookite type (pyromelane), and an anatase type (octahedrite). Preferably, a rutile type is used.

A crystal system of the titanium oxide is not particularly limited. Examples of the crystal system thereof include a tetragonal system and an orthorhombic system. Preferably, a tetragonal system is used.

When the crystal structure and the crystal system of the titanium oxide are the rutile type and the tetragonal system, respectively, it is possible to effectively prevent a reduction of the reflectivity with respect to light (to be specific, visible light, among all, the light around the wavelength of 450 nm) even in a case where the reflector portion 34 is exposed to a high temperature for a long time.

The light reflecting component is in the form of a particle. The shape thereof is not limited and examples of the shape thereof include a sphere shape, a plate shape, and a needle shape. The average value of the maximum length (in the case of a sphere shape, the average particle size) of the light reflecting component is, for example, 1 nm or more and 1000 nm or less. The average value of the maximum length is measured using a laser diffraction scattering particle size analyzer.

The mixing ratio of the light reflecting component with respect to 100 parts by mass of the resin is, for example, 30 parts by mass or more, or preferably 50 parts by mass or more, and is, for example, 200 parts by mass or less, or preferably 100 parts by mass or less.

The above-described light reflecting component is uniformly dispersed and mixed in the resin.

Also, the above-described filler can be further added to the reflecting resin composition. That is, the filler can be used in combination with the light reflecting component (to be specific, a white pigment).

An example of the filler includes a known filler excluding the above-described white pigment. To be specific, examples of the filler include organic microparticles such as silicone particles and inorganic microparticles such as silica, talc, alumina, aluminum nitride, and silicon nitride.

The addition ratio of the filler is adjusted so that the total amount of the filler and the light reflecting component with respect to 100 parts by mass of the resin is, for example, 400 parts by mass or more, preferably 500 parts by mass or more, or more preferably 600 parts by mass or more, and is, for example, 2500 parts by mass or less, preferably 2000 parts by mass or less, or more preferably 1600 parts by mass or less.

In the laminating method, the reflecting resin composition is prepared in an A-stage state by blending the above-described resin and light reflecting component, and the filler, which is added as required, to be uniformly mixed.

Subsequently, in the laminating method, the reflecting resin composition in an A-stage state is applied to the surface of a release sheet that is not shown by an application method such as a casting, a spin coating, or a roll coating and thereafter, the applied product is heated to be brought into a B-stage state or C-stage state. An example of the release sheet includes the same one as the above-described release sheet 13.

Alternatively, for example, the reflecting resin composition in an A-stage state is applied to the surface of a release sheet that is not shown using a screen printing or the like by the above-described application method and thereafter, the applied product is heated to form the reflector sheet 42 in a B-stage state or C-stage state.

Thereafter, the reflector sheet 42 is transferred onto the releasing sheet 49. Subsequently, the release sheet that is not shown is peeled off.

On the other hand, in the application method, the above-described reflecting resin composition in an A-stage state is applied to the upper surface of the releasing sheet 49 using a screen printing or the like and thereafter, the applied product is heated to form the reflector sheet 42 in a B-stage state.

The thickness of the reflector sheet 42 is, for example, 0.3 mm or more, or preferably 0.5 mm or more, and is, for example, 5 mm or less, or preferably 3 mm or less.

Subsequently, as shown by the arrows in FIG. 5 (a), and in FIG. 5 (b), the reflector sheet 42 is pressed by the pressing device 35.

To be specific, the die 37 is pushed down with respect to the support board 36. To be more specific, the die 37 is pushed downwardly so that the extruded portions 39 pass through the reflector sheet 42 in the thickness direction. Along with this, the circumference end portion of the flat plate portion 38 in the die 37 is brought into contact with the upper surface of the spacer 40.

In this way, as shown in FIG. 5 (b), in the reflector sheet 42, through holes 41, which pass through the reflector sheet 42 in the thickness direction and are in shapes corresponding to the extruded portions 39, are formed.

In the pushing down of the die 37, when the reflecting resin composition contains a thermosetting resin in a B-stage state, a heater (not shown) is built in the die 37 in advance and the reflector sheet 42 can be also heated by the heater. In this way, the reflecting resin composition is completely cured (is brought into a C-stage state).

The heating temperature is, for example, 80°C or more, or preferably 100°C or more, and is, for example, 200°C or less, or preferably 180°C or less.

In this way, the reflector portion 34 is formed on the releasing sheet 49.

Thereafter, as shown in FIG. 5 (c), a pressing state of the pressing device 35 is released. To be specific, the die 37 is pulled up.

Subsequently, the die 37 including the flat plate portion 38 and the extruded portions 39 is replaced with the die 37 including the flat plate portion 38 only.

Along with this, the phosphor sheet 5 is disposed on the reflector portion 34.

To be specific, the phosphor sheet 5 is disposed on the upper surface of the reflector portion 34 so as to cover the through holes 41.

When the phosphor resin composition contains a curable resin, the phosphor sheet 5 in a B-stage state is disposed on the reflector portion 34. The phosphor sheet 5 in a B-stage state can retain its flat plate shape to some extent, so that it is disposed on the upper surface of the reflector portion 34 so as to cover the through holes 41 without falling into the inside of the through holes 41.

The phosphor sheet 5 is formed to be more flexible than the reflector portion 34 (to be specific, the reflector portion 34 in a C-stage state when the reflecting resin composition of the reflector sheet 42 contains a curable resin). To be specific, the reflector portion 34 is formed to have non-deformable hardness by the next pressing (ref: FIG. 5 (d)), while the phosphor sheet 5 is formed to have defonnable flexibility by the next pressing.

Next, as shown in FIG. 5 (d), the phosphor sheet 5 is pressed by the pressing device 35. To be specific, the die 37 made of the flat plate portion 38 is pushed down toward the support board 36. Along with this, the circumference end portion of the flat plate portion 38 is brought into contact with the upper surface of the spacer 40. The lower surface of the flat plate portion 38 is in contact with the upper surface of the reflector portion 34.

In this way, the relatively flexible phosphor sheet 5 is pressed from the upper side by the flat plate portion 38 to fill the through holes 41. On the other hand, the relatively hard reflector portion 34 is not deformed and houses the embedding portions 33 in the through holes 41 therein.

When the curable resin is a thermosetting resin, the phosphor sheet 5 can be heated by a heater that is built in the flat plate portion 38.

In this way, the embedding portions 33 are formed in the through holes 41 in the reflector portion 34.

In this way, the embedding-reflector sheet 24 including the embedding portions 33 and the reflector portion 34 is obtained between the support board 36 and the die 37.

Thereafter, as shown in FIG. 5 (e), the die 37 is pulled up and subsequently, the embedding-reflector sheet 24 is peeled from the releasing sheet 49.

Next, using the embedding-reflector sheet 24 shown in FIG. 5 (e), a method for producing the phosphor sheet-covered LED 10 and the LED device 15, which has different steps from those in the above-described embodiment, is described in detail with reference to FIG. 3.

[Sheet Attaching Step]

As shown by the upper side view in FIG. 3 (b), the embedding-reflector sheet 24 is disposed above the support sheet 1 so that each of the embedding portions 33 is formed into a tapered shape in which its width is gradually reduced toward the lower side.

That is, each of a plurality of the embedding portions 33 is disposed in opposed relation to each of a plurality of the LEDs 4. To be specific, each of the embedding portions 33 is disposed to be opposed to the center of each of the LEDs 4 and each of the LEDs 4 is also disposed at spaced intervals to the inner side of the reflector portion 34 in plane view.

Subsequently, as shown in FIG. 3 (c), the embedding-reflector sheet 24 is pressed. In this way, each of the LEDs 4 is embedded in each of the embedding portions 33 so that the upper surface and the side surfaces of the LED 4 are covered with the embedding portion 33.

When the embedding portion 33 is in a B-stage state, the upper surface and the side surfaces of the LED 4 and the upper surface of the pressure-sensitive adhesive layer 3 are covered with the embedding portion 33 in close contact with each other.

[Encapsulating Step]

As shown in FIG. 3 (d), in the encapsulating step, when the phosphor resin composition contains a curable resin, the phosphor sheet 5 is cured. In this way, the embedding portions 33 are completely cured. In this way, each of the LEDs 4 is encapsulated by each of the embedding portions 33.

[Cutting Step]

As shown by the dashed lines in FIG. 3 (d), in the cutting step, the reflector portion 34 is cut along the thickness direction. As shown by the dash-dot lines in FIG. 4, for example, the phosphor sheet 5 is cut so that the reflector portion 34 is formed into a generally rectangular shape in plane view that surrounds each of the embedding portions 33.

By the cutting step, the phosphor sheet-covered LEDs 10, each of which includes one LED 4, the embedding portion 33 that embeds the LED 4, and the reflector portion 34 that is provided around the embedding portion 33, are obtained in a state of being in close contact with the support sheet 1. That is, each of the phosphor sheet-covered LEDs 10 includes the reflector portion 34. That is, the phosphor sheet-covered LED 10 is a reflector portion-including phosphor sheet-covered LED 10.

[LED Peeling Step]

In the LED peeling step, as shown in FIG. 3 (e), each of the phosphor sheet-covered LEDs 10 each including the reflector portion 34 is peeled from the support sheet 1.

[Mounting Step]

In the mounting step, after the phosphor sheet-covered LED 10 including the reflector portion 34 is selected in accordance with emission wavelength and luminous efficiency, as shown in FIG. 3 (f), the selected phosphor sheet-covered LED 10 is mounted on the board 9. In this way, the LED device 15 is obtained.

In this way, the LED device 15 including the board 9 and the phosphor sheet-covered LED 10 that is mounted on the board 9 and includes the reflector portion 34 is obtained.

According to the second embodiment, the embedding-reflector sheet 24 includes the embedding portion 33 that embeds the LED 4 and the reflector portion 34 that contains a light reflecting component and is formed so as to surround the embedding portion 33, so that light emitted from the LED 4 can be reflected by the reflector portion 34. Thus, the luminous efficiency of the LED device 15 can be improved.

<Modified Example>

Furthermore, the release sheet 13 (ref: the phantom lines in FIG. 3 (b)) is provided between the flat plate portion 38 and the phosphor sheet 5 that are shown in FIG. 5 (c) to form the embedding-reflector sheet 24 in which the release sheet 13 is laminated on the upper surface thereof. Thereafter, as shown by the phantom lines in FIG. 3 (c), the embedding-reflector sheet 24 can be also, for example, subjected to flat plate pressing with respect to a plurality of the LEDs 4 and the support sheet 1.

<Third Embodiment>

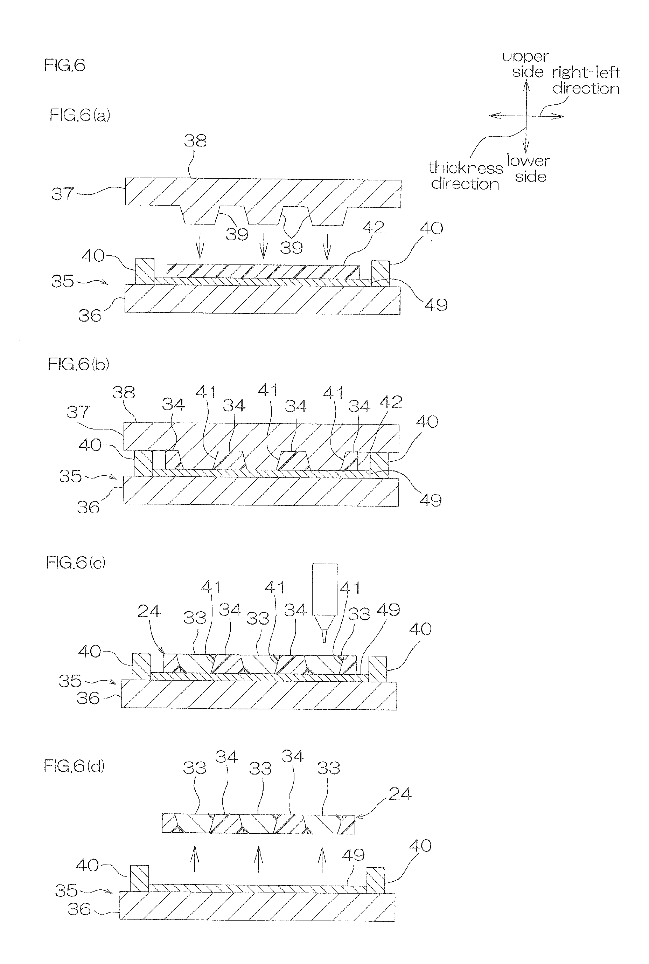

FIG. 6 shows process drawings for illustrating a method for producing an embedding-reflector sheet used in a third embodiment of a method for producing a phosphor layer-covered LED of the present invention.

In the third embodiment, the same reference numerals are provided for members and steps corresponding to each of those in the second embodiment, and their detailed description is omitted.

In the method for producing the embedding-reflector sheet 24 in the second embodiment, as shown in FIGS. 5 (c) and 5 (d), the embedding portions 33 are formed of the phosphor sheet 5. Alternatively, for example, as shown in FIG. 6 (c), the embedding portions 33 can be also formed by potting a varnish of a phosphor resin composition into the through holes 41 without using the phosphor sheet 5.

To be specific, first, the phosphor resin composition is prepared as a varnish. To be specific, when the phosphor resin composition contains a curable resin, a varnish in an A-stage state is prepared. In this way, the phosphor resin composition in an A-stage state fills the through holes 41.

Thereafter, when the phosphor resin composition contains a curable resin, the phosphor resin composition in an A-stage state is brought into a B-stage state.

In the third embodiment, the same function and effect as that of the second embodiment can be achieved.

<Fourth Embodiment>

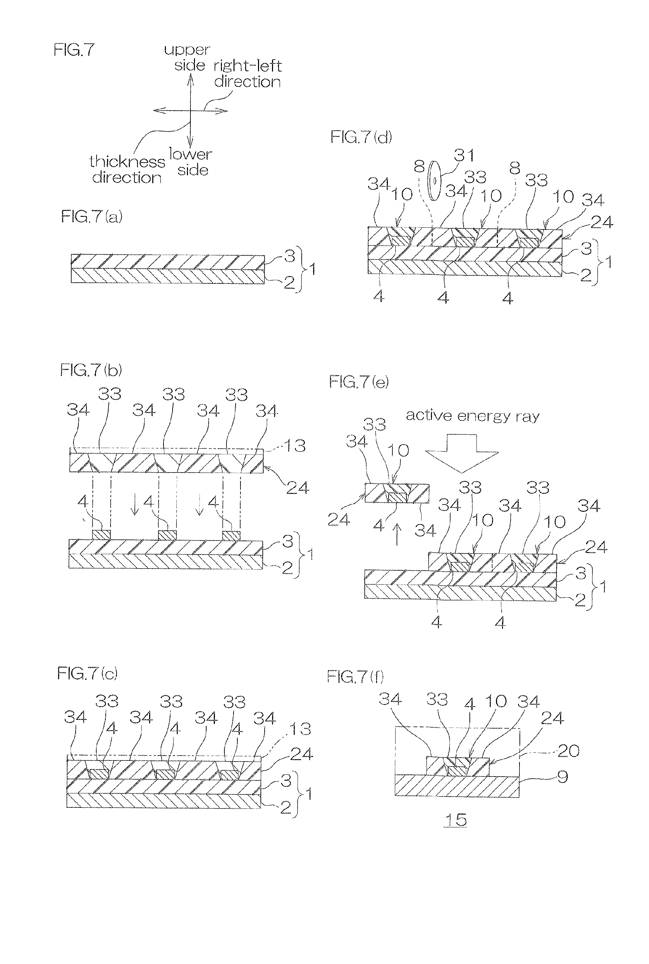

FIG. 7 shows process drawings for illustrating a fourth embodiment of a method for producing a phosphor layer-covered LED of the present invention.

In the fourth embodiment, the same reference numerals are provided for members and steps corresponding to each of those in the second and third embodiments, and their detailed description is omitted.

In the second embodiment, as shown in FIGS. 3 (b) and 4, the lower end portion of the embedding portion 33 is formed to be larger than the LED 4 in plane view. Alternatively, for example, as shown in FIG. 7 (b), the lower end portion of the embedding portion 33 can be formed to be the same size as that of the LED 4.

[LED Attaching Step]

Each of the embedding portions 33 is, for example, formed into a generally quadrangular pyramid trapezoidal shape in which its width is gradually reduced toward the lower side.

In order to form the embedding portions 33 shown in FIG. 7 (b), each of the extruded portions 39 referred in FIGS. 5 and 6 is formed into a generally quadrangular pyramid trapezoidal shape in which its width is gradually reduced from the lower surface of the flat plate portion 38 toward the lower side.

Also, as shown by the dash-dot lines in FIG. 7 (b), the embedding-reflector sheet 24 is disposed on the pressure-sensitive adhesive layer 3 including the LEDs 4 so that, when projected in the thickness direction, the lower end portion of each of the embedding portions 33 is overlapped with each of the LEDs 4, to be specific, the circumference end edge of the lower end portion of each of the embedding portions 33 is formed at the same position as the circumference end edge of each of the LEDs 4 in plane view.

In the fourth embodiment, the same function and effect as those of the fifth and eighth embodiments can be achieved.

<Fifth Embodiment>

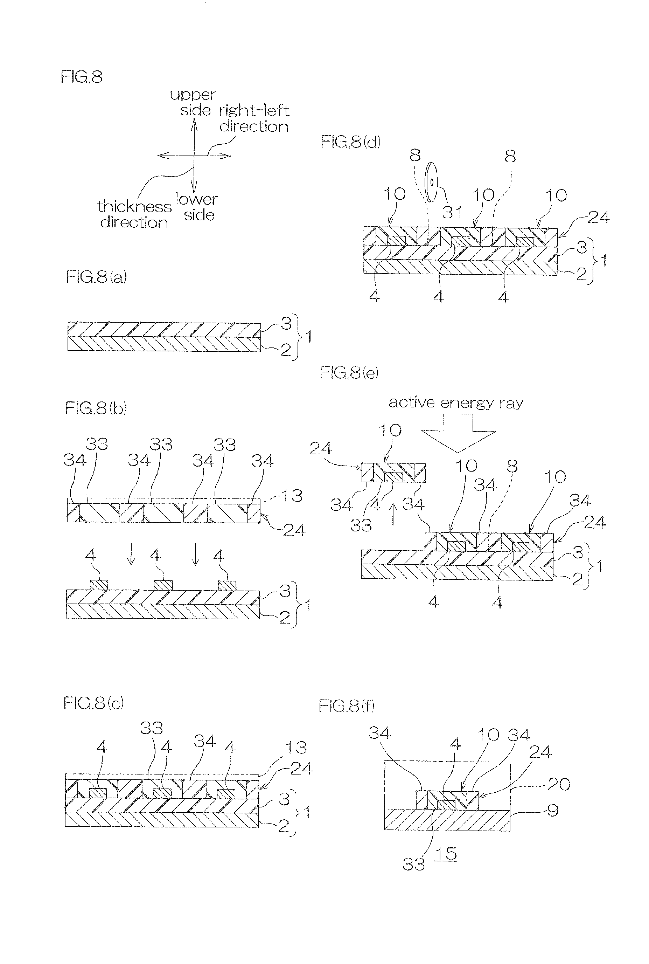

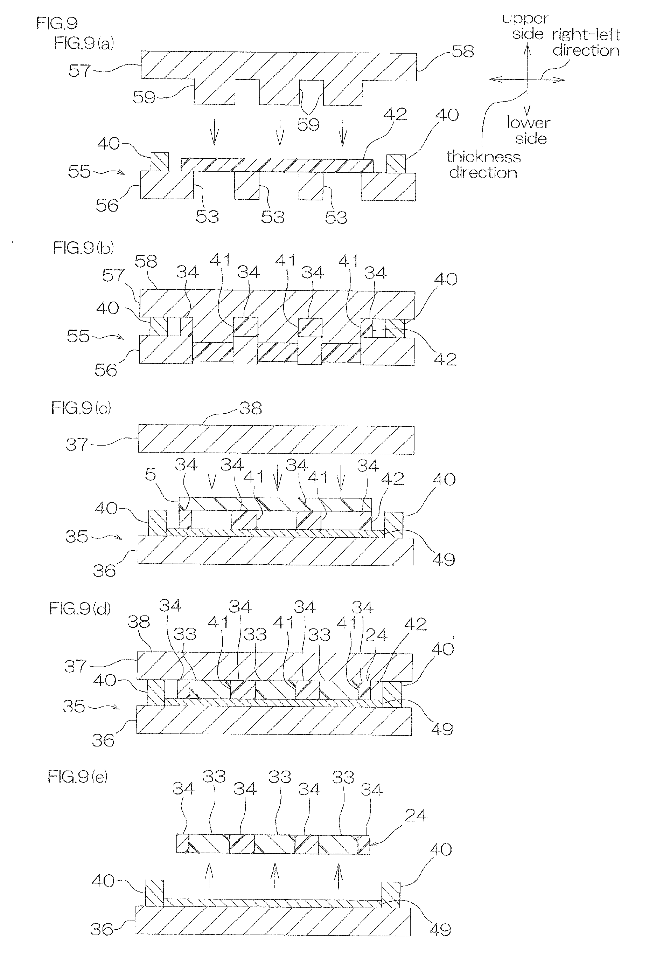

FIG. 8 shows process drawings for illustrating a fifth embodiment of a method for producing a phosphor layer-covered LED of the present invention. FIG. 9 shows process drawings for illustrating a method for producing the embedding-reflector sheet shown in FIG. 8 (b).

In the fifth embodiment, the same reference numerals are provided for members and steps corresponding to each of those in the second embodiment, and their detailed description is omitted.

In the second embodiment, as shown in FIG. 3 (b), each of the embedding portions 33 in the embedding-reflector sheet 24 is formed into a generally conical trapezoidal shape in which its width is gradually reduced toward the lower side. Alternatively, for example, as shown in FIG. 8 (b), each of the embedding portions 33 can be also formed into a generally column shape extending in the up-down direction (the thickness direction).

In order to form the embedding portions 33, a punching device 55 shown in FIGS. 9 (a) and 9 (b) is used.

The punching device 55 is provided with a support board 56 and a die 57 that is disposed in opposed relation to the upper side of the support board 56.

The support board 56 is, for example, formed of a metal such as stainless steel into a generally rectangular flat plate shape. Through holes 53 that pass through the support board 56 in the thickness direction are formed.

Each of the through holes 53 is formed into a generally circular shape in plane view.

The die 57 integrally includes a flat plate portion 58 and extruded portions 59 that are formed to be extruded downwardly from the flat plate portion 58.

The flat plate portion 58 is formed into the same shape as that of the flat plate portion 38 shown in FIG. 5 (a).

In the die 57, a plurality of the extruded portions 59 are disposed at spaced intervals to each other in the plane direction so as to correspond to the embedding portions 33 (ref: FIG. 9 (d)). That is, each of the extruded portions 59 is formed into the same shape and the same size as those of each of the through holes 53 in plane view, to be specific, into a generally column shape. Each of the extruded portions 59 is formed into the same shape as that of each of the embedding portions 33 (ref: FIG. 9 (d)). That is, each of the extruded portions 59 is formed into a generally rectangular shape in front sectional view and side sectional view.

In this way, the punching device 55 is configured to allow the extruded portions 59 to be capable of being inserted into the through holes 53 by the pushing down of the die 57.

The hole diameter of each of the through holes 53 and the diameter of each of the extruded portions 59 are, for example, 5 mm or more, or preferably 7 mm or more, and are, for example, 300 mm or less, or preferably 200 mm or less.

The spacer 40 is provided on the upper surface of the circumference end portion of the support board 56. The spacer 40 is, in plane view, disposed in a generally frame shape in plane view at the circumference end portion of the support board 56 so as to surround the through holes 53.

In order to form the embedding-reflector sheet 24 by the punching device 55 shown in FIGS. 9 (a) and 9 (b), first, as shown in FIG. 9 (a), the reflector sheet 42 is disposed on the support board 56. To be specific, the reflector sheet 42 is disposed on the upper surface of the support board 56 so as to cover a plurality of the through holes 53.

Next, as shown in FIG. 9 (b), the reflector sheet 42 is stamped out using the punching device 55.

To be specific, the extruded portions 59 stamp out the reflector sheet 42 by pushing down the die 57.

In this way, the through holes 41 in shapes corresponding to the extruded portions 59 are formed in the reflector sheet 42.

In this way, the reflector portion 34 is formed on the support board 56.

Next, as shown in FIG. 9 (c), the die 57 is pulled up.

Thereafter, the formed reflector portion 34 is disposed in the pressing device 35 that is provided with the support board 36 and the die 37 made of the flat plate portion 38, and includes the releasing sheet 49.

Next, the phosphor sheet 5 is disposed on the reflector portion 34.

Next, as shown by the arrows in FIG. 9 (c), and in FIG. 9 (d), the phosphor sheet 5 is pressed by the pressing device 35. In this way, the embedding portions 33 are formed in the inside of the through holes 41 in the reflector portion 34.

In this way, the embedding-reflector sheet 24 including the embedding portions 33 and the reflector portion 34 is obtained between the support board 36 and the die 37.

Thereafter, the die 37 is pulled up and subsequently, as shown in FIG. 9 (e), the embedding-reflector sheet 24 is peeled from the releasing sheet 49.

In the fifth embodiment, the same function and effect as that of the second embodiment can be achieved.

<Sixth Embodiment>

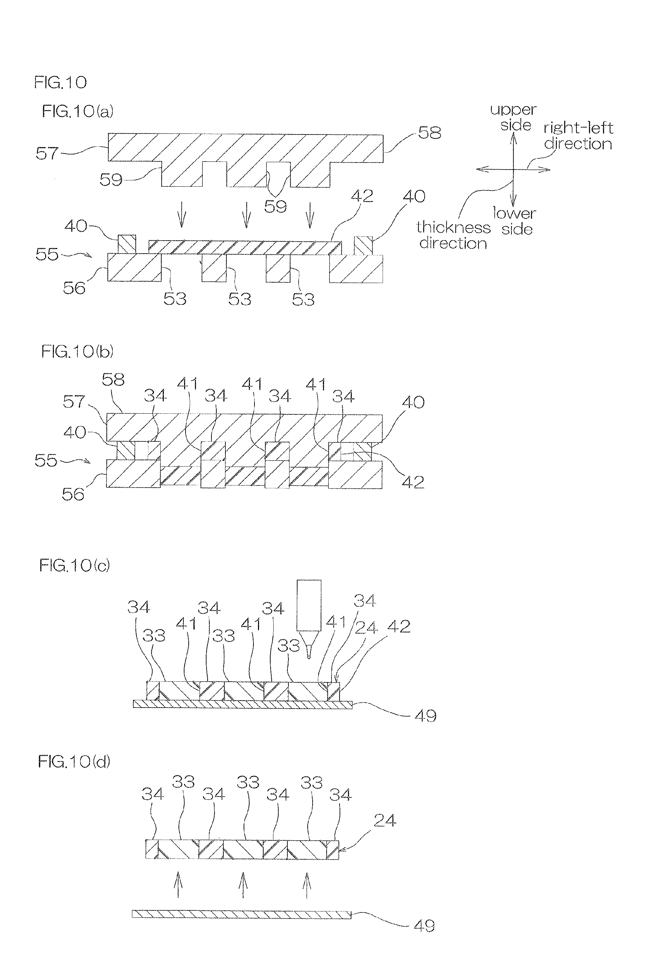

FIG. 10 shows process drawings for illustrating a method for producing an embedding-reflector sheet used in a sixth embodiment of a method for producing a phosphor layer-covered LED of the present invention.

In the sixth embodiment, the same reference numerals are provided for members and steps corresponding to each of those in the fifth embodiment, and their detailed description is omitted.

In the method for producing the embedding-reflector sheet 24 in the fifth embodiment, as shown in FIGS. 9 (c) and 9 (d), the embedding portions 33 are formed of the phosphor sheet 5. Alternatively, for example, as shown in FIG. 10 (c), the embedding portions 33 can be also formed by potting a varnish of a phosphor resin composition into the through holes 41 without using the phosphor sheet 5.

To be specific, the reflector portion 34 shown in FIG. 10 (b) is taken out from the punching device 55 to be subsequently, as shown in FIG. 10 (c), disposed on the upper surface of the releasing sheet 49. Then, the varnish of the phosphor resin composition is potted into the through holes 41.

In the sixth embodiment, the same function and effect as that of the fifth embodiment can be achieved.

<Seventh Embodiment>

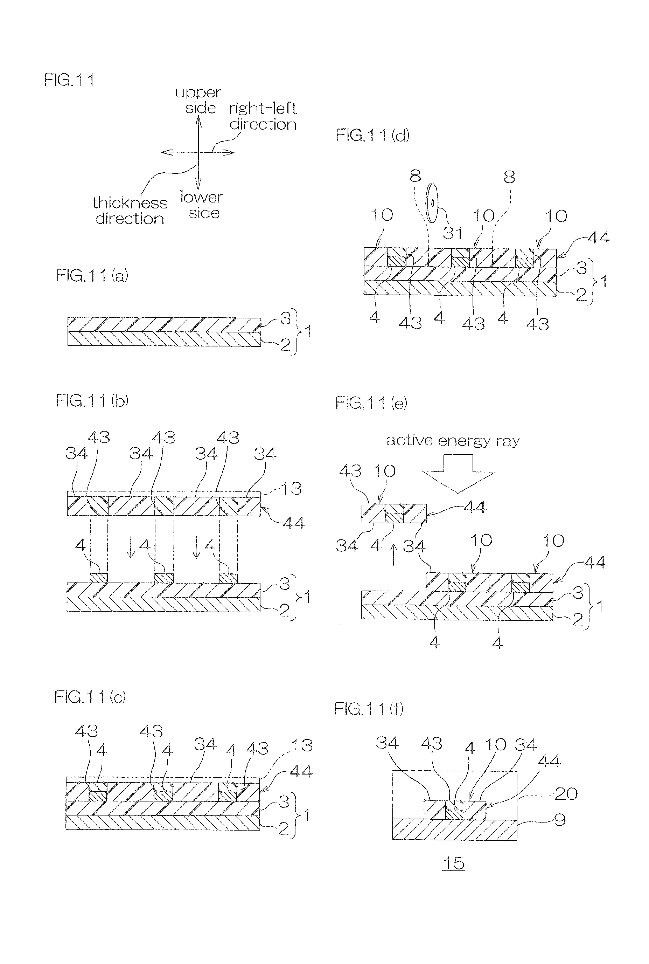

FIG. 11 shows process drawings for illustrating a seventh embodiment of a method for producing a phosphor layer-covered LED of the present invention.

In the seventh embodiment, the same reference numerals are provided for members and steps corresponding to each of those in the fifth embodiment, and their detailed description is omitted.

In the fifth embodiment, as shown in FIG. 8 (c), the embedding portions 33 that embed the LEDs 4 are illustrated as cover portions. Alternatively, for example, as shown in FIG. 11 (c), cover portions 43 that cover the upper surfaces of the LEDs 4 can be also illustrated.

As shown in FIG. 11 (b), the cover portions 43 are provided in a cover-reflector sheet 44 so as to be surrounded by the reflector portion 34. In the cover-reflector sheet 44, each of the cover portions 43 is formed into the same shape as that of each of the embedding portions 33 shown in FIG. 8 (b) and furthermore, is formed into the same size as that of each of the LEDs 4.

As shown in FIG. 11 (b), for example, each of the cover portions 43 is disposed on the upper surface of each of the LEDs 4 so that each of the cover portions 43 is overlapped with each of the LEDs 4 when projected in the thickness direction, to be specific, the circumference end edge of each of the cover portions 43 is formed at the same position as the circumference end edge of each of the LEDs 4 in plane view.

[Covering Step]

In the seventh embodiment, the covering step shown in FIG. 11 (c) is performed instead of the embedding step shown in FIG. 8 (c). The conditions of the covering step are the same as those of the embedding step.

In the covering step shown in FIG. 11 (c), each of the cover portions 43 covers the upper surface of each of the LEDs 4 in close contact with each other. The LED 4 is pressed into the cover portion 43 by pressing of the LED 4, so that the cover portion 43 slightly expands outwardly in the plane direction. The degree of expansion thereof is subtle, so that in FIG. 11 (c), the lengths in the right-left direction of the cover portion 43 and the LED 4 after the pressing are shown to be the same.

[Curing Step]

In the seventh embodiment, the curing step shown in FIG. 11 (d) is performed instead of the encapsulating step shown in FIG. 8 (d).

In the curing step, the cover portions 43 are cured. The conditions of the curing step are the same as those of the above-described encapsulating step.

In the seventh embodiment, the same function and effect as that of the fifth embodiment can be achieved.

<Eighth Embodiment>

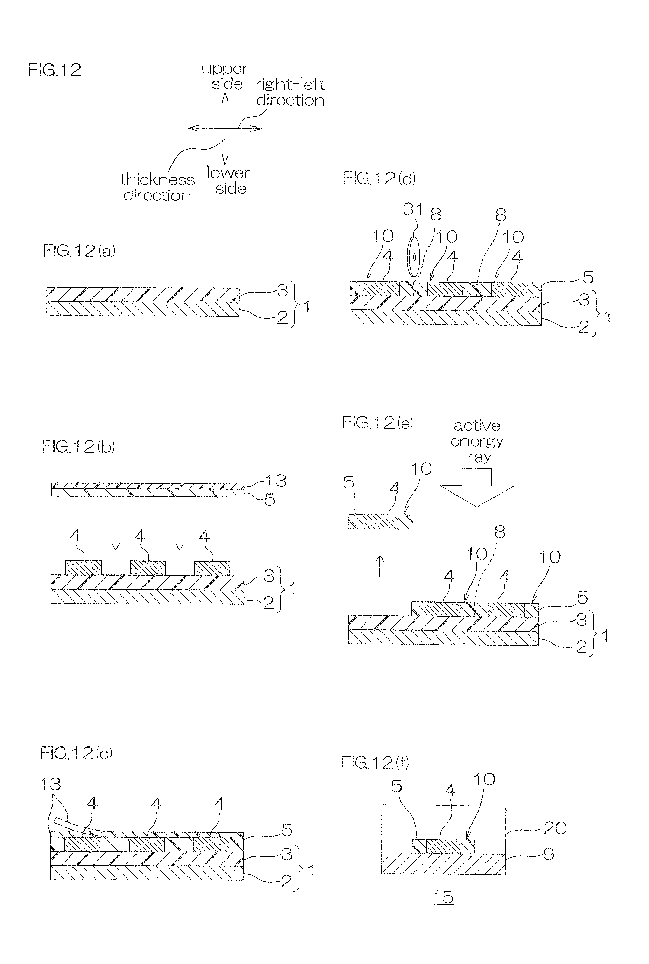

FIG. 12 shows process drawings for illustrating an eighth embodiment of a method for producing a phosphor layer-covered LED of the present invention.

In the eighth embodiment, the same reference numerals are provided for members and steps corresponding to each of those in the first embodiment, and their detailed description is omitted.

In the first embodiment, as shown in FIG. 1 (c), in the sheet attaching step, the embedding step in which the side surfaces and the upper surfaces of the LEDs 4 are covered with the phosphor sheet 5 is performed. Alternatively, for example, as shown in FIG. 12 (c), the covering step in which the side surfaces only of the LEDs 4 are covered with the phosphor sheet 5 can be performed instead of the embedding step. Also, the curing step can be performed instead of the encapsulating step.

[Sheet Attaching Step]

As shown in FIG. 12 (b), the thickness of the prepared phosphor sheet 5 is set to be thinner than that of each of the LEDs 4, that is, set to be, for example, 95 % or less, or preferably 90 % or less, and to be, for example, 10 % or more with respect to the thickness of each of the LEDs 4. To be specific, the thickness of the phosphor sheet 5 is set to be, for example, 1000 µm or less, or preferably 800 µm or less, and to be, for example, 30 µm or more, or preferably 50 µm or more.

As shown in FIG. 12 (c), in the covering step, a laminate (ref: the upper side view in FIG. 12 (b)) made of the release sheet 13 and the phosphor sheet 5 laminated on the lower surface of the release sheet 13 is pressed into the support sheet 1 including the LEDs 4 so that the lower surface of the release sheet 13 is in contact with the upper surfaces of the LEDs 4 by the pressing.

The upper surface of the phosphor sheet 5, which is pressed into gaps between a plurality of the LEDs 4, is formed to be flush with the upper surfaces of the LEDs 4. The lower surface of the phosphor sheet 5 is also formed to be flush with the lower surfaces of the LEDs 4. That is, the thickness of the phosphor sheet 5, which is pressed into gaps between a plurality of the LEDs 4, is the same as that of each of the LEDs 4.

The side surfaces of the LED 4 are covered with the phosphor sheet 5, while both a bump that forms a portion of the lower surface of the LED 4 and the upper surface of the LED 4 are exposed from the phosphor sheet 5.

[Curing Step]

In the curing step, the phosphor sheet 5 is cured. The conditions of the curing step are the same as those of the above-described encapsulating step.

[Cutting Step]

As shown by the dashed lines in FIG. 12 (d), the phosphor sheet 5 is cut, while the position of the LEDs 4 is checked from the upper side. To be specific, in the phosphor sheet 5, the position of the LEDs 4 is checked, while the LEDs 4 are visually confirmed from the upper side with, for example, a camera. As referred in the dashed lines in FIG. 4, the phosphor sheet 5 is cut so that the cuts 8 that define a region surrounding each of the LEDs 4 are formed in plane view.

The phosphor sheet 5 can be also cut, while the LEDs 4 are visually confirmed, in addition, with the reference marks 18 (ref: FIG. 2) as a reference.

[LED Peeling Step]

In FIG. 12 (e), in the LED peeling step, each of the phosphor sheet-covered LEDs 10 is peeled from the upper surface of the pressure-sensitive adhesive layer 3. That is, each of the phosphor sheet-covered LEDs 10 is peeled from the support board 2 and the pressure-sensitive adhesive layer 3 so that interfacial peeling occurs between the phosphor sheet 5 and the LEDs 4, and the pressure-sensitive adhesive layer 3.

In the eighth embodiment, the same function and effect as that of the first embodiment can be achieved.

In addition, in the covering step, the side surfaces of the LEDs 4 are covered with the phosphor sheet 5 so that at least the upper surfaces of the LEDs 4 are exposed from the phosphor sheet 5. Thus, in the cutting step after the sheet attaching step, the LEDs 4 having the upper surfaces exposed are visually confirmed and the phosphor sheet 5 can be accurately cut corresponding to the LEDs 4. Therefore, the phosphor sheet-covered LED 10 to be obtained has excellent size stability. As a result, the LED device 15 including the phosphor sheet-covered LED 10 has excellent luminous stability.

<Ninth Embodiment>

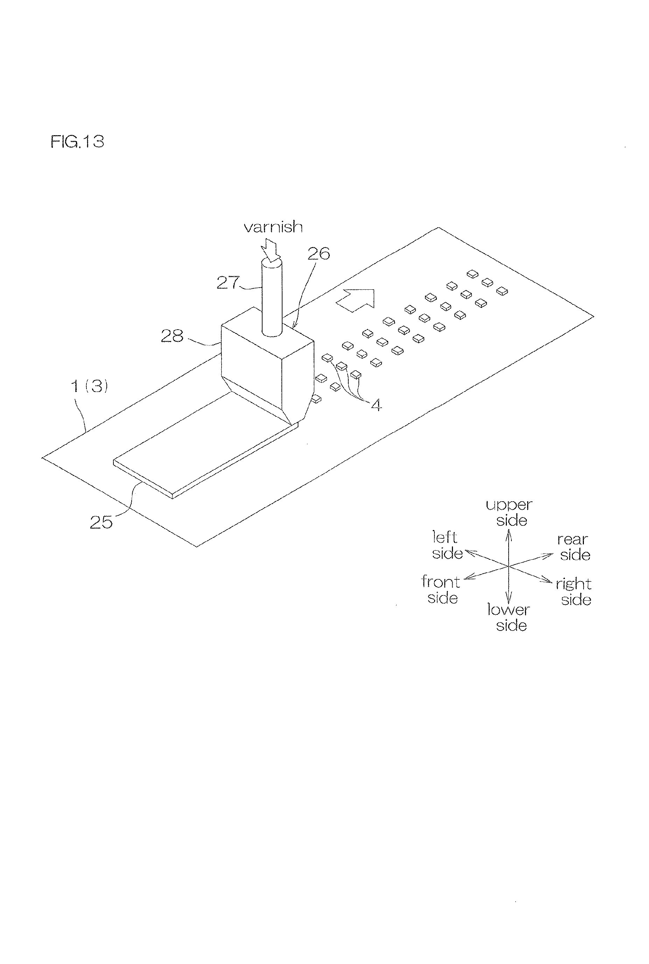

FIG. 13 shows a perspective view of a dispenser used in a ninth embodiment of a method for producing a phosphor layer-covered LED of the present invention.

In the ninth embodiment, the same reference numerals are provided for members and steps corresponding to each of those in the first embodiment, and their detailed description is omitted.

In the first embodiment, as shown in FIG. 1 (b), in the encapsulating step, the phosphor sheet 5 that is formed in advance is illustrated as one example of the phosphor layer of the present invention. Alternatively, as referred in FIG. 13, for example, a phosphor resin composition is prepared as a varnish and the varnish is directly applied onto the support sheet 1 so as to cover a plurality of the LEDs 4, so that a phosphor layer 25 can be also formed. That is, the phosphor layer 25 can be formed from the varnish of the phosphor resin composition.

In order to form the phosphor layer 25, first, the varnish is applied onto the support sheet 1 so as to cover the LEDs 4.

In order to apply the varnish, for example, an application device such as a dispenser, an applicator, or a slit die coater is used. Preferably, a dispenser 26 shown in FIG. 13 is used.

As shown in FIG. 13, the dispenser 26 integrally includes an introduction portion 27 and an application portion 28.

The introduction portion 27 is formed into a generally cylindrical shape extending in the up-down direction and the lower end portion thereof is connected to the application portion 28.

The application portion 28 is formed into a flat plate shape extending in the right-left and the up-down directions. The application portion 28 is formed into a generally rectangular shape in side view that is long in the up-down direction. The introduction portion 27 is connected to the upper end portion of the application portion 28. The lower end portion of the application portion 28 is formed into a tapered shape in sectional side view in which the front end portion and the rear end portion are cut off. The lower end surface of the application portion 28 is configured to be capable of being pressed with respect to the upper surface of the pressure-sensitive adhesive layer 3 and the upper surfaces of the LEDs 4. Furthermore, at the inside of the application portion 28, a broad flow path (not shown) in which a varnish introduced from the introduction portion 27 gradually expands in the right-left direction as it goes toward the lower section (downwardly) is provided.

The dispenser 26 is configured to be movable relatively in the front-rear direction with respect to the support sheet 1 extending in the plane direction.

In order to apply the varnish to the support sheet 1 using the dispenser 26, the application portion 28 is disposed in opposed relation (pressed) to the upper surfaces of a plurality of the LEDs 4 and the varnish is supplied to the introduction portion 27. Along with this, the dispenser 26 is moved relatively toward the rear side with respect to a plurality of the LEDs 4. In this way, the varnish is introduced from the introduction portion 27 into the application portion 28 and subsequently, is broadly supplied from the lower end portion of the application portion 28 to the support sheet 1 and the LEDs 4. By the relative movement of the dispenser 26 toward the rear side with respect to a plurality of the LEDs 4, the varnish is applied onto the upper surface of the support sheet 1 in a belt shape extending in the front-rear direction so as to cover a plurality of the LEDs 4.

When the phosphor resin composition contains a curable resin, the varnish is prepared in an A-stage state. When the varnish is, for example, supplied from the application portion 28 to the support sheet 1, it does not flow out of its position outwardly in the plane direction. That is, the varnish has viscous properties of keeping its position. To be specific, the viscosity of the varnish under conditions of 25°C and 1 pressure is, for example, 1,000 mPa·s or more, or preferably 4,000 mPa·s or more, and is, for example, 1,000,000 mPa·s or less, or preferably 100,000 mPa·s or less. The viscosity is measured by adjusting a temperature of the varnish to 25°C and using an E-type cone at a number of revolutions of 99 s⁻¹.

When the viscosity of the varnish is not less than the above-described lower limit, the varnish can be effectively prevented from flowing outwardly in the plane direction. Thus, it is not required to separately provide a dam member or the like in the support sheet 1 (to be specific, around a plurality of the LEDs 4), so that a simplified process can be achieved. Then, the varnish can be easily and surely applied to the support sheet 1 with a desired thickness and a desired shape with the dispenser 26.

On the other hand, when the viscosity of the varnish is not more than the above-described upper limit, the application properties (the handling ability) can be improved.

Thereafter, when the phosphor resin composition contains a curable resin, the applied varnish is brought into a B-stage state (a semi-cured state).

In this way, the phosphor layer 25 in a B-stage state is formed on the support sheet 1 (on the upper surface of the pressure-sensitive adhesive layer 3) so as to cover a plurality of the LEDs 4.

In the ninth embodiment, the same function and effect as that of the first embodiment can be achieved.

<Modified Example>

In the first to ninth embodiments, a plurality of the LEDs 4 are covered with the phosphor sheet 5. Alternatively, for example, a single piece of the LED 4 can be covered with the phosphor sheet 5.

In such a case, to be specific, in the cutting step shown in FIG. 1 (d) that is illustrated in the first embodiment, the phosphor sheet 5 around the LED 4 is trimmed (subjected to trimming) so as to have a desired size.

## Claims

1. A method for producing a phosphor layer-covered LED (10) comprising:
a preparing step of preparing a support sheet (1) including a hard support board (2) and a pressure-sensitive adhesive layer (3) laminated at one surface in a thickness direction of the support board and having a pressure-sensitive adhesive force capable of being reduced by application of an active energy ray;
an LED attaching step of attaching an LED (4) to the support board via the pressure-sensitive adhesive layer;
a covering step of disposing a phosphor layer (5) at the one surface in the thickness direction of the support board so as to cover the LED with the phosphor layer;
a cutting step of, after the covering step, cutting the phosphor layer (5) corresponding to the LED (4) to produce a phosphor layer-covered LED (10) including the LED and the phosphor layer covering the LED; and
an LED peeling step of, after the cutting step, peeling the phosphor layer-covered LED (10) from the pressure-sensitive adhesive layer (3) by applying an active energy ray at least from one side in the thickness direction to the pressure-sensitive adhesive layer.

2. The method for producing a phosphor layer-covered LED according to claim 1, wherein the phosphor layer is formed of a phosphor sheet (5).

3. The method for producing a phosphor layer-covered LED according to claim 1 or 2, wherein
in the covering step, the LED (4) is covered with the phosphor layer (5) that is in a B-stage state and thereafter, the phosphor layer is cured to be brought into a C-stage state.

4. The method for producing a phosphor layer-covered LED according to claim 1, 2 or 3, wherein
the phosphor layer (5) includes
a cover portion (33, 43) that covers the LED (4) and
a reflector portion (34) that contains a light reflecting component and is formed so as to surround the cover portion (33, 43).

5. The method for producing a phosphor layer-covered LED according to any of claims 1 to 4, wherein
in the preparing step, the support sheet is prepared so that a reference mark (18), which serves as a reference of cutting in the cutting step, is provided in advance.

6. A phosphor layer-covered LED obtained by a method for producing a phosphor layer-covered LED according to any of claims 1 to 5.

7. An LED device (15) comprising:
a board (9) and
a phosphor layer-covered LED (10) mounted on the board (9), wherein
the phosphor layer-covered LED is obtained by a method for producing a phosphor layer-covered LED according to any of claims 1 to 5.
